# EUROPEAN PATENT APPLICATION

(11) **EP 4 700 774 A1**
(43) Date of publication of application: **25.02.2026**
(21) Application number: 25195951.6
(22) Date of filing: 14.08.2025
(51) Int. Cl.: G11C 5/02, H10B 80/00

(54) **DOUBLE SIDE MEMORY ARRAY WITH BACKSIDE CONNECTION**

(30) Priority: 16.08.2024 US 202418806803
(71) Applicant: Kioxia Corporation, Tokyo 105-8001 (JP)
(72) Inventor: RYU, Albert B., San Jose, CA, 95134 (JP)
(74) Representative: Hoffmann Eitle

(57) **Abstract**

Disclosed herein are related to a device comprising a memory chip, another memory chip, and a circuit chip between the memory chip and the another memory chip, where the circuit chip is connected to the memory chip and the another memory chip through different connections. The memory chip may include a first memory array and a first bond pad, and the another memory chip may include a second memory array and a second bond pad. The circuit chip may include a third bond pad on a first surface of the circuit chip coupled to the first bond pad, and a fourth bond pad on a second surface of the circuit chip coupled to the second bond pad. The circuit chip may include a transistor coupled to the third bond pad through a front side connection and another transistor coupled to the fourth bond pad through a backside connection.

## Description

### TECHNICAL FIELD

Disclosed herein are generally related to stacked memory chips with a circuit chip provided between the memory chips.

### BACKGROUND

A memory device is an electronic device that can store data. A memory device can be a volatile memory device or a non-volatile memory device. A volatile memory device such as a random access memory (RAM) device can retain data while power is provided, but may not retain the data when the power is no longer provided. Meanwhile, a non-volatile memory device such as a read only memory (ROM) device or a flash memory device can retain data, even when power is absent.

### BRIEF DESCRIPTION OF THE DRAWINGS

These and other aspects and features of the present arrangements will become apparent to those ordinarily skilled in the art upon review of the following description of specific arrangements in conjunction with the accompanying figures.
FIG. 1 is a block diagram illustrating an example configuration of a device, according to some embodiments.
FIG. 2 is a circuit diagram illustrating an example circuit configuration of NAND memory cells in a block of a memory array, according to some embodiments.
FIG. 3 is a circuit diagram illustrating an example circuit configuration of a sense amplifier in a memory device, according to some embodiments.
FIG. 4 is a circuit diagram illustrating an example circuit configuration of a sense amplifier unit of a sense amplifier, according to some embodiments.
FIG. 5 is a circuit diagram illustrating a portion of a memory device showing an example circuit configuration of a row decoder, according to some embodiments.
FIG. 6 is a blown-up perspective view illustrating an example structure of a memory device, according to some embodiments.
FIG. 7 is a cross-sectional view illustrating an example structure of a memory device, according to some embodiments.
FIG. 8 is a cross-sectional view illustrating an example structure of a memory device, according to some embodiments.
FIG. 9 is a cross-sectional view illustrating an example structure of a memory device, according to some embodiments.
FIG. 10 is a cross-sectional view illustrating an example structure of a memory device, according to some embodiments.
FIG. 11 is a perspective view illustrating an example structure of a circuit chip, according to some embodiments.
FIG. 12 is a cross-sectional view illustrating an example structure of a memory device, according to some embodiments.
FIG. 13 is a cross-sectional view illustrating an example structure of a memory device, according to some embodiments.
FIG. 14 is a cross-sectional view illustrating an example structure of a memory device, according to some embodiments.
FIG. 15 is a cross-sectional view illustrating an example structure of a memory device, according to some embodiments.
FIG. 16 is a flow chart illustrating an example process of performing operations on memory chips with a circuit chip in between the memory chips through interconnects in opposite sides of the circuit chip, according to some embodiments.

### DETAILED DESCRIPTION

Disclosed herein are related to a device including a circuit chip between two memory chips, where the circuit chip is connected to different memory chips through connections provided in different sides of the circuit chip.

In one configuration, the device includes a first memory chip including a first memory array and a first bond pad coupled to the first memory array. In one configuration, the device includes a second memory chip including a second memory array and a second bond pad coupled to the second memory array. In one configuration, the device includes a circuit chip disposed between the first memory chip and the second memory chip. In one configuration, the circuit chip is disposed above the second memory chip, and the first memory chip is disposed above the circuit chip. The circuit chip may include a third bond pad coupled to the first bond pad and a fourth bond pad coupled to the second bond pad. The circuit chip may also include a first transistor and a second transistor disposed on a substrate. The first transistor may be coupled to the third bond pad through a front side interconnect, and the second transistor may be coupled to the fourth bond pad through a backside interconnect.

In some embodiments, a front side interconnect (may be also referred to as "a front side connection") is a conductive structure coupled to a front side of a first transistor facing the first memory chip. For example, the front side interconnect may directly contact a front side of a source/drain of the first transistor facing the first memory chip. Meanwhile, in some embodiments, a backside interconnect (may be also referred to as "a backside connection") is a conductive structure coupled to a rear side of the second transistor facing the second memory chip. The backside interconnect may penetrate a rear surface of the substrate facing the second memory chip to directly contact a rear side of a source/drain of the second transistor facing the second memory chip.

Advantageously, the disclosed device can achieve improved performance and storage density. In one implementation, a memory chip and a circuit chip can be formed by different fabrication processes, and then the memory chip and the circuit chip can be stacked together. The memory chip and the circuit chip can be formed by different fabrication processes, for example, in different temperatures, different deposition techniques, and/or different etching techniques to improve or optimize performances or characteristics (e.g., yield, density, speed, power consumption, etc.) of the memory chip and the circuit chip. In this implementation, the memory chip and the circuit chip can be electrically connected through bond pads. However, a number of bond pads allowed between the memory chip and the circuit chip may correspond to a surface area of the memory chip or the circuit chip. Hence, the number of channels or memory cells that can be provided above a single surface of the circuit chip may be set by the amount of connections available through the bond pads on the single surface of the circuit chip. In one aspect, the disclosed device implements a circuit chip between a first memory chip and a second memory chip, where the circuit chip is electrically connected to the first memory chip and the second memory chip through bond pads on opposite surfaces of the circuit chip. Because the circuit chip can be electrically connected to different memory chips through bond pads on opposite surfaces of the circuit chip, sufficient number of bond pads can be provided to achieve doubled or increased storage density.

Advantageously, the circuit chip of the disclosed device implements backside interconnects to allow flexible arrangements. In one aspect, the circuit chip includes a semiconductor substrate and a first transistor and a second transistor disposed on the substrate. The first transistor and the second transistor may be disposed on a same surface of the substrate. The first transistor may be connected to the first memory chip through the front side interconnect and a bond pad on a surface of the circuit chip facing the first memory chip. Meanwhile, the second transistor may be connected to the second memory chip through the backside interconnect and a bond pad on an opposite surface of the circuit chip facing the second memory chip. In one aspect, backside interconnects enable flexible placements or arrangements of various circuit components (e.g., transistors) and bond pads. Such flexible placements and arrangements of circuit components and bond pads may allow the circuit chip and memory chips to have improved characteristics (e.g., higher speed, lower power consumption, etc.), for example, by obviating long interconnects or reducing critical paths. In one example, due to flexibility in placements and arrangements of circuit components and bond pads, the first memory chip and the second memory chip may have an identical configuration formed by the same fabrication process, such that the fabrication costs can be reduced.

Advantageously, the circuit chip of the disclosed device can simultaneously perform operations on memory cells in different memory chips through interconnects of different sides. In one aspect, the circuit chip can perform a first operation on a first memory cell of the first memory chip through the front side interconnect. Examples of the first operation include reading or verifying data stored by the first memory cell, writing data to the first memory cell, and erasing data stored by the first memory cell. For example, the circuit chip may apply a voltage or current to the first memory cell through the front side interconnect, or receive a voltage or current from the first memory cell through the front side interconnect to perform the first operation. The circuit chip may also perform a second operation on a second memory cell of the second memory chip through the backside interconnect. Examples of the second operation include reading or verifying data stored by the second memory cell, writing data to the second memory cell, and erasing data stored by the second memory cell. For example, the circuit chip may apply a voltage or current to the second memory cell through the backside interconnect, or receive a voltage or current from the second memory cell through the backside interconnect to perform the second operation. In one aspect, the circuit chip can simultaneously perform operations on memory cells in different memory chips through interconnects of different sides, such that the read or write speed of the circuit chip can be improved.

In various embodiments disclosed herein, transistors can be implemented in various circuits. Transistors can be metal oxide semiconductor field effect transistors (MOSFETs), finFETs, gate all around FETs (GAAFETs), nanosheet transistors, or any transistors. Each transistor may have a source and a drain, where such source and drain can be interchangeable.

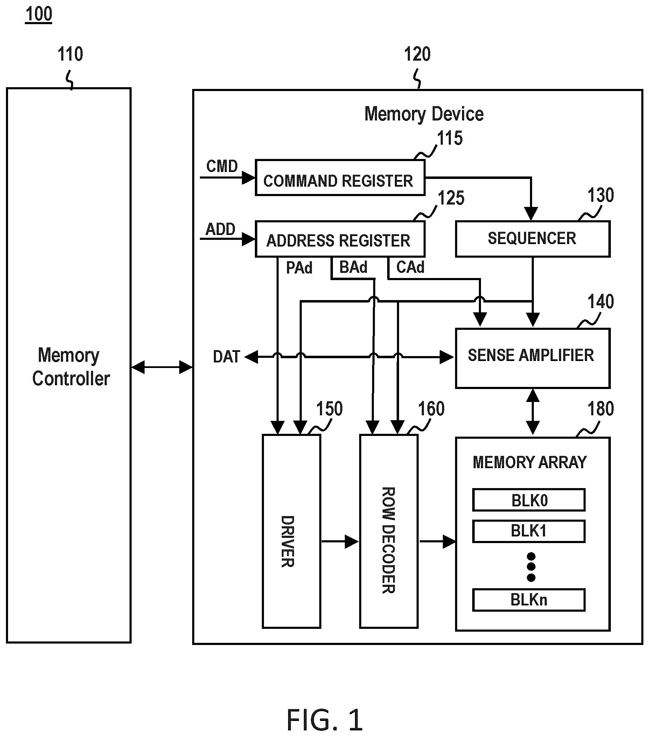

FIG. 1 illustrates an example configuration of a device 100 that can store data, according to some embodiments. In some embodiments, the device 100 is a discrete storage system, such as a memory card, a solid state drive (SSD) or the like. In some embodiments, the device 100 includes a memory controller 110 and a memory device 120. In some embodiments, the device 100 has a different configuration than shown in FIG. 1. For example, the device 100 may include more, fewer, or different components than shown in FIG. 1. In some embodiments, the device 100 can be any computing device, such as a personal computer, a laptop, a mobile device, a tablet device, an Internet of Thing (IoT) device, or a server computer, including the memory controller 110 and the memory device 120.

In some embodiments, the memory device 120 is a hardware device or component that can store data. The memory device 120 can be a volatile memory device or a non-volatile memory device. Examples of the volatile memory device include a static RAM device, a dynamic RAM device, a high bandwidth memory (HBM) device, etc. Examples of the non-volatile memory device include a NAND flash memory device, a NOR flash memory device, magnetic tunnel junction (MTJ) device, phase-change memory (PCM) device, resistive memory device, etc. In some embodiments, the memory device 120 includes, for example, a command register 115, an address register 125, a sequencer 130, a sense amplifier 140, a driver 150, a row decoder 160, and a memory array 180.

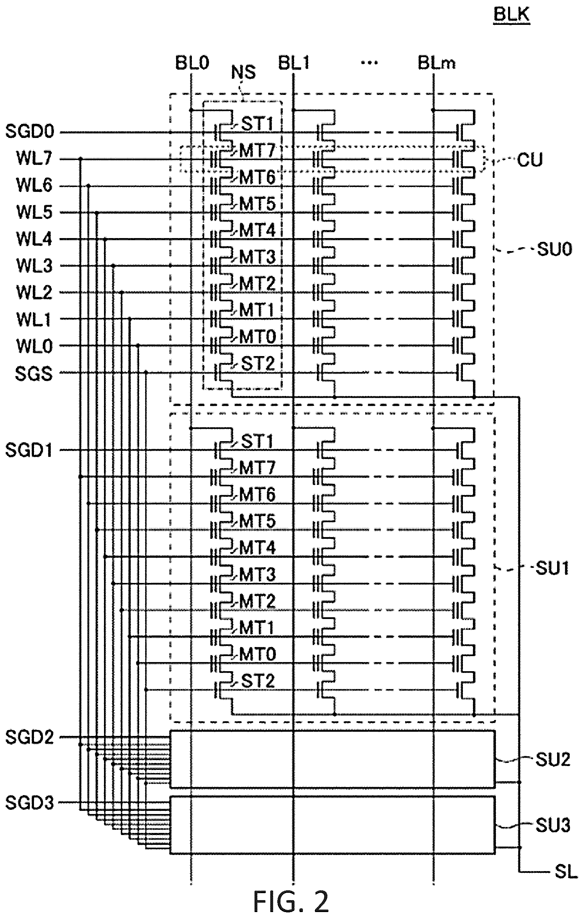

In some embodiments, the memory array 180 includes a plurality of blocks BLK0 to BLKn (n is an integer of 1 or more). The block BLK may be a set of memory cells capable of storing data, where the set of memory cells can be erased together as a group. The memory cells may be volatile memory cells or non-volatile memory cells. In some embodiments, the memory array 180 includes NAND flash memory cells with more than one hundred layers or two hundred layers. In one configuration, the memory array 180 includes a plurality of bit lines and a plurality of word lines. Each memory cell can be associated with, for example, one bit line and one word line. Detailed description on example implementation and operation of the memory array 180 is provided below with respect to FIG. 2. Although a single memory array 180 is shown in FIG. 1, the memory device 120 may include two or more memory arrays 180.

In some embodiments, the command register 115 is a circuit or a component that can receive a command CMD, and latch or store the received command CMD. Examples of the command CMD include, for example, a command for causing the sequencer 130 to execute a read operation, a verify operation, a write operation, an erase operation, etc. The command register 115 may be implemented as a register circuit, a logic circuit or any component that can store data in a volatile manner. In one configuration, the command register 115 includes an input port connected to the memory controller 110, and an output port connected to the sequencer 130. In this configuration, the command register 115 can receive a command CMD from the memory controller 110 and latch or store the received command CMD. The command register 115 may transmit the latched or stored command CMD to the sequencer 130.

In some embodiments, the address register 125 is a circuit or a component that can receive address information ADD, and latch or store the received address information ADD. The address register 125 may be implemented as a register circuit, a logic circuit, or any component that can store data in a volatile manner. In one configuration, the address register 125 includes an input port connected to the memory controller 110, a first output port connected to the driver 150, a second output port connected to the row decoder 160, and a third output port connected to the sense amplifier 140. In this configuration, the address register 125 can receive address information ADD from the memory controller 110, and latch or store the received address information ADD. The address information ADD may indicate, for example, a block address BAd, a page address PAd, and a column address CAd. For example, the block address BAd, the page address PAd, and the column address CAd can be utilized for selecting a block BLK, a word line, and a bit line, respectively. The address register 125 may transmit the page address PAd to the driver 150, the block address BAd to the row decoder 160, and the column address CAd to the sense amplifier 140.

In some embodiments, the sequencer 130 (may be also referred to as a controller) is a circuit or a component that controls various components of the memory device 120. In some embodiments, the sequencer 130 is implemented as an application specific integrated circuit (ASIC), field programmable gate array (FPGA), logic circuits, or any combination thereof. In one configuration, the sequencer 130 includes an input port connected to the output port of the command register 115, and an output port connected to the sense amplifier 140, the driver 150, and the row decoder 160. In this configuration, the sequencer 130 can transmit signals or instructions to coordinate operations of the sense amplifier 140, the driver 150, and the row decoder 160, according to the command CMD from the command register 115 to execute a read operation, a verify operation, a write operation, an erase operation, etc.

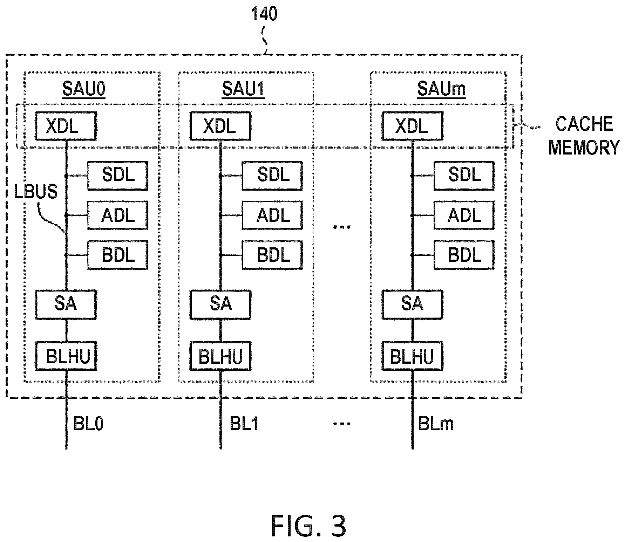

In some embodiments, the sense amplifier 140 is a circuit or a component that can apply a voltage or current to the memory array 180 and receive a voltage or current from the memory array 180. In some embodiments, the sense amplifier 140 is implemented as an analog circuit or a combination of an analog circuit and a logic circuit. In one configuration, the sense amplifier 140 includes an input port connected to the output port of the sequencer 130, an input port connected to the third output port of the address register 125, a bi-directional port connected to the memory controller 110, and a bi-directional port connected to one or more bit lines of the memory array 180. In this configuration, in response to an instruction or a signal from the sequencer 130 to write data, the sense amplifier 140 can apply a target voltage or current to one or more bit lines of the memory array 180 corresponding to the column address CAd, according to write data DAT received from the memory controller 110. In response to an instruction or a signal from the sequencer 130 to read data, the sense amplifier 140 can detect or sense a voltage or current of a bit line connected to a target memory cell corresponding to the column address CAd, where such detection or sensing may correspond to read data DAT. The sense amplifier 140 may transmit the read data DAT to the memory controller 110. Detailed description on example implementation and operation of the sense amplifier 140 is provided below with respect to FIG. 3.

In some embodiments, the driver 150 is a circuit or a component that generates voltages for performing various operations of the memory device 120. In some embodiments, the driver 150 is implemented as an analog circuit or a combination of an analog circuit and a logic circuit. In one configuration, the driver 150 includes an input port connected to the first output port of the address register 125, an input port connected to the output port of the sequencer 130, and an output port connected to the row decoder 160. In this configuration, the driver 150 can receive an instruction or a signal from the sequencer 130, and generate voltages for performing a read operation, a verify operation, a write operation, an erase operation, etc., as indicated by the instruction or the signal from the sequencer 130. The driver 150 can change or generate different voltages for different word lines of the memory array 180, according to the page address PAd from the address register 125. The driver 150 can apply the generated voltages to the row decoder 160.

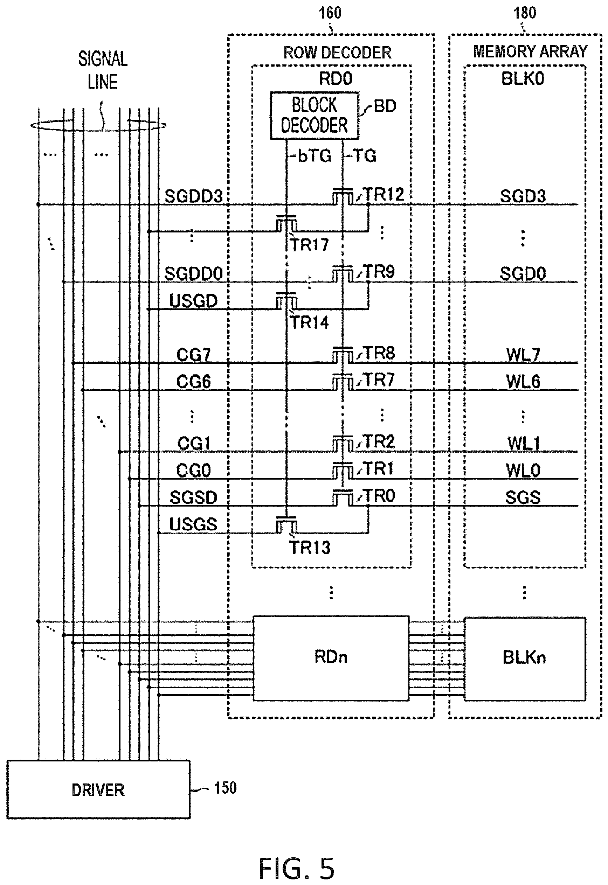

In some embodiments, the row decoder 160 is a circuit or a component that provides voltages from the driver 150 to one or more blocks BLKs of the memory array 180. In some embodiments, the row decoder 160 can be implemented as a logic circuit. In one configuration, the row decoder 160 includes an input port connected to the output port of the driver 150, an input port connected to the second output port of the address register 125, an input port connected to the output port of the sequencer 130, and an output port connected to the memory array 180. In this configuration, the row decoder 160 can electrically connect the driver 150 to a block BLK of the memory array 180 corresponding to the block address BAd received from the address register 125. One or more voltages generated by the driver 150 can be applied to one or more word lines of the selected block BLK. Detailed description on example implementation and operation of the row decoder 160 is provided below with respect to FIG. 5.

In some embodiments, the memory controller 110 is a device or a component that can communicate with a host device or a processor (not shown), and control or cause an operation of the memory device 120. In some embodiments, the memory controller 110 can be implemented as an ASIC, FPGA, logic circuits, or any combination thereof. In one configuration, the memory controller 110 is communicatively coupled between the memory device 120 and the host device. In this configuration, the memory controller 110 can interface with the host device, and cause read, verify, write, or erase operation on the memory device 120. For example, in response to a request from the host device to write data at a particular address, the memory controller 110 can transmit a command CMD, a corresponding address information ADD indicative of a target memory cell, and data DAT to write to the memory device 120. For example, in response to a request from the host device to read data at a particular address, the memory controller 110 can transmit a command CMD, and a corresponding address information ADD indicative of a target memory cell to the memory device 120, and receive data DAT from the memory device 120 in return. In one aspect, the memory controller 110 may manage blocks of memory cells with a logical-to-physical address translation. In some embodiments, the memory controller 110 and the memory device 120 may be implemented as separate integrated circuit devices. In some embodiments, the memory controller 110 and the memory device 120 may be integrated as a single integrated circuit device. In some embodiments, some features (e.g., logical-to-physical address translation) of the memory controller 110 may be implemented or performed by the memory device 120.

FIG. 2 illustrates an example circuit configuration of NAND memory cells in a block BLK of the memory array 180, according to some embodiments. In FIG. 2, the block BLK includes, for example, four string units SU0 to SU3. In some embodiments, the block BLK has a different configuration than shown in FIG. 2. For example, the block BLK may have more, fewer, or different components than shown in FIG. 2. For example, the block BLK may include a different number of string units SU than shown in FIG. 2.

In some embodiments, each string unit SU includes a plurality of NAND strings NS that are associated with bit lines BL0 to BLm (m is an integer greater than or equal to 1), respectively. Each NAND string NS includes, for example, memory cell transistors MT0 to MT7, and select transistors ST1 and ST2. Each memory cell transistor MT may store one bit data as a single level memory cell (SLC), two-bits data as a multi-level memory cell (MLC), three-bits data as a triple level memory cell (TLC), four-bits data as a quad level memory cell (QLC), or a larger number of bits of data. The memory cell transistor MT may include a gate and a charge storage layer, and can store data in a non-volatile manner. Each of the select transistors ST1 and ST2 can be used for a selection of a string unit SU.

In one configuration, in each NAND string NS, the memory cell transistors MT0 to MT7 are connected to each other in series. In one configuration, the drain of the select transistor ST1 is connected to an associated bit line BL, and the source of the select transistor ST1 is connected to one end of the memory cell transistors MT0 to MT7, which are connected to each other in series. In one configuration, the drain of the select transistor ST2 is connected to the other end of the memory cell transistors MT0 to MT7. In one configuration, the source of the select transistor ST2 is connected to a source line SL.

In one configuration, in the same block BLK, gates of memory cell transistors MT0 to MT7 of different string units SU are connected in common to corresponding word lines WL0 to WL7, respectively. For example, gates of memory cell transistors MT7 of different string units SU0, SU1, SU2, SU3 in the same block BLK are connected in common to a word line WL7, and gates of memory cell transistors MT6 of different string units SU0, SU1, SU2, SU3 in the same block BLK are connected in common to a word line WL6. In one configuration, gates of select transistors ST1 in a same string unit SU are connected in common to a corresponding select gate line SGD. For example, gates of the select transistors ST1 in the string unit SU0 are connected to a select gate line SGD0, and gates of the select transistors ST1 in the string unit SU1 are connected to a select gate line SGD1. In one configuration, gates of the select transistors ST2 in the same block BLK are connected in common to a select gate line SGS.

In one aspect, in the above-described circuit configuration of the memory array 180, the bit line BL may be shared by NAND strings NS, to which the same column address is allocated, in the respective string units SU. In one aspect, the source line SL may be shared among, for example, the plurality of blocks BLK.

A set of a plurality of memory cell transistors MT connected to the common word line WL in one string unit SU may be referred to as, for example, a cell unit CU. For example, the storage capacity of the cell unit CU that includes the memory cell transistors MT in a string unit SU connected to the same word line may correspond to "one page data." The cell unit CU may have a storage capacity of two or more pages of data according to the number of bits of data stored in each memory cell transistor MT.

The circuit configuration of the memory array 180 in the memory device 120 may not be limited to the above-described circuit configuration. For example, each NAND string NS may have a different number (e.g., more than one hundred or more than two hundred) of memory cell transistors MT than shown in FIG. 2. For example, each NAND string NS may have additional select transistors ST1 and ST2 than shown in FIG. 2. For example, each block BLK may have a different number of string units SU than shown in FIG. 2.

FIG. 3 illustrates an example circuit configuration of the sense amplifier 140 in the memory device 120, according to some embodiments. In some embodiments, the sense amplifier 140 includes, for example, sense amplifier units SAU0 to SAUm. The sense amplifier units SAU0 to SAUm may be associated with corresponding bit lines BL0 to BLm, respectively. The sense amplifier unit SAU may be a circuit or a component that can sense or detect a voltage of a corresponding bit line BL. The sense amplifier unit SAU may also apply a voltage to the corresponding bit line BL. In some embodiments, each sense amplifier unit SAU includes, for example, a bit line connector BLHU, a sense amplifier circuit SA, a bus LBUS, and latch circuits SDL, ADL, BDL and XDL. In some embodiments, the sense amplifier 140 has a different configuration than shown in FIG. 3. For example, the sense amplifier 140 may have more, fewer, or different components than shown in FIG. 3.

In one configuration, the bit line connector BLHU is connected between the associated bit line BL and the sense amplifier circuit SA. Through the bit line connector BLHU, the sense amplifier circuit SA may receive a voltage or current from the associated bit line BL, or apply a voltage or current to the associated bit line BL.

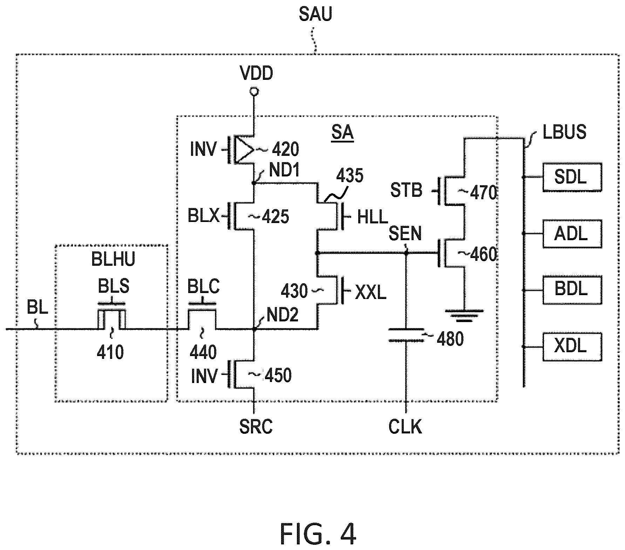

In one configuration, the sense amplifier circuit SA, and the latch circuits SDL, ADL, BDL and XDL are connected to the bus LBUS, and are capable of transmitting/receiving data to/from each other via the bus LBUS. Each of the latch circuits SDL, ADL, BDL and XDL may temporarily store data, etc. In one configuration, the latch circuit XDL is connected to an input/output circuit (not illustrated) of the memory device 120, and can be utilized for data input/output between the sense amplifier unit SAU and the input/output circuit. The latch circuit XDL may also be used as, for example, a cache memory of the memory device 120. Detailed description on example configuration and operation of a sense amplifier unit SAU is provided below with respect to FIG. 4.

FIG. 4 illustrates an example circuit configuration of a sense amplifier unit SAU of the sense amplifier 140, according to some embodiments. In some embodiments, the bit line connector BLHU includes a transistor 410, and the sense amplifier circuit SA includes transistors 420, 425, 430, 435, 440, 450, 460, 470, and a capacitor 480. In some embodiments, the sense amplifier unit SAU has a different configuration than shown in FIG. 4. For example, the sense amplifier unit SAU may have more, fewer, or different components than shown in FIG. 4. For example, the sense amplifier unit SAU may have a different number of latch circuits, according to the number of pages to be stored in one cell unit CU. In some embodiments, the sequencer 130 may generate various control signals BLX, HLL, XXL, BLC, STB, and BLS, and the clock signal CLK, and apply the signals to the sense amplifier unit SAU to cause various operations of the sense amplifier unit SAU. In some embodiments, the sequencer 130 may also generate and apply signals or voltages to nodes INV, SRC of the sense amplifier unit SAU.

In some embodiments, the transistor 420 is a P-type transistor. In some embodiments, the transistors 410, 425, 430, 435, 440, 450, 460, 470 are N-type transistors. In some embodiments, the transistor 410 is an N-type transistor having a higher breakdown voltage than the transistors 425, 430, 435, 440, 450, 460, 470.

In one configuration, a source of the transistor 420 is connected to a power rail providing a supply voltage VDD, and a drain of the transistor 420 is connected to a node ND1. In one configuration, a gate of the transistor 420 is connected to, for example, a node INV in the latch circuit SDL. In one configuration, a drain of the transistor 425 is connected to the node ND1, and a source of the transistor 425 is connected to a node ND2. In one configuration, a control signal BLX is applied to a gate of the transistor 425. In one configuration, a drain of the transistor 435 is connected to the node ND1, and a source of the transistor 435 is connected to a node SEN. In one configuration, a control signal HLL is applied to a gate of the transistor 435. In one configuration, a drain of the transistor 430 is connected to the node SEN, and a source of the transistor 430 is connected to the node ND2. In one configuration, a control signal XXL is applied to the gate of the transistor 430. In one configuration, a drain of the transistor 440 is connected to the node ND2. In one configuration, a control signal BLC is applied to the gate of the transistor 440. In one configuration, a drain of the transistor 450 is connected to the node ND2, and a source of the transistor 450 is connected to a node SRC. In one configuration, a gate of the transistor 450 is connected to, for example, the node INV in the latch circuit SDL.

In one configuration, a source of the transistor 460 is connected to a metal rail providing, for example, a 0 V (or ground voltage). In one configuration, the gate of the transistor 460 is connected to the node SEN. In one configuration, a drain of the transistor 470 is connected to the bus LBUS, and a source of the transistor 470 is connected to a drain of the transistor 460. In one configuration, a control signal STB is applied to a gate of the transistor 470. In one configuration, one electrode of the capacitor 480 is connected to the node SEN, and another electrode of the capacitor 480 receives a clock signal CLK.

In one configuration, a drain of the transistor 410 is connected to a source of the transistor 440, and a source of the transistor 410 is connected to the bit line BL. The transistor 410 may have a high breakdown voltage to withstand a large voltage difference between the bit line BL and the node ND2 of the sense amplifier circuit SA. In one configuration, a control signal BLS is applied to the gate of the transistor 410. In this configuration, the transistor 410 operates as a switch between the bit line BL and the sense amplifier circuit SA. For example, in response to the control signal BLS having a first voltage higher than a threshold voltage of the transistor 410, the transistor 410 can be enabled to electrically couple the bit line BL to the sense amplifier circuit SA. For example, in response to the control signal BLS having a second voltage lower than the threshold voltage of the transistor 410, the transistor 410 can be disabled to electrically decouple the bit line BL from the sense amplifier circuit SA.

In one aspect, various control signals (e.g., BLX, HLL, XXL, BLC, STB, BLS, the clock signal CLK, and signals or voltages applied to the nodes SRC, INV, etc.) can be applied, for example by the sequencer 130, to the sense amplifier unit SAU to apply a voltage to the bit line BL for performing a write operation, read, verify, or erase operation. In one approach, the sequencer 130 can apply signals to disable the transistors 430, 435, 450, and apply signals to enable the transistors 410, 420, 425, 440 to electrically couple the bit line BL to the power rail providing the supply voltage VDD, such that the supply voltage VDD can be applied to the bit line BL.

In one aspect, various control signals (e.g., BLX, HLL, XXL, BLC, STB, BLS, the clock signal CLK, and signals or voltages applied to the nodes SRC, INV, etc.) can be applied, for example by the sequencer 130, to the sense amplifier unit SAU to receive a voltage at the bit line BL for performing a read operation or a verify operation. In one approach, the sequencer 130 can apply signals to disable the transistors 410, 425, 430, 440, 450, and apply signals to enable the transistors 420, 435 to electrically couple the power rail providing the supply voltage VDD to the node SEN to pre-charge the capacitor 480. After pre-charging the capacitor 480, the sequencer 130 can apply signals to disable the transistors 420, 425, 435, 450 and apply signals to enable the transistors 410, 430, 440 to electrically couple the bit line BL to the node SEN. While the transistors 410, 430, 440 are enabled, the capacitor 480 may be discharged, according to a state of a memory cell connected to the bit line BL. For example, according to a memory cell having a first state, the capacitor 480 may discharge, so that a voltage at the node SEN may become lower than a threshold voltage of the transistor 460. For example, according to a memory cell having a second state, the capacitor 480 may not discharge, so that a voltage at the node SEN may be maintained higher than the threshold voltage of the transistor 460. At a predetermined time after the transistors 410, 430, 440 are enabled for discharging, the sequencer 130 may apply the signal STB to enable the transistor 470. When the transistor 470 is enabled, the transistor 460 may conduct current to change a voltage at the LBUS, according to the voltage at the node SEN. Hence, a voltage corresponding to or indicative of a state of a memory cell can be provided to the LBUS, which can be provided to the latch SDL, ADL, BDL or XDL with a corresponding page.

FIG. 5 illustrates a portion of the memory device 120 showing an example circuit configuration of the row decoder 160, according to some embodiments. In some embodiments, the row decoder 160 is connected to the driver 150 via, for example, signal lines CGO to CG7, SGDDO to SGDD3, SGSD, USGD, USGS. The driver 150 may apply various voltages to a selected block BLK through the signal lines CG0 to CG7, SGDDO to SGDD3, SGSD. The driver 150 may also apply a ground voltage (e.g., 0 V) to one or more non-selected blocks BLK through the signal lines USGD and USGS. In some embodiments, the row decoder 160 has a different configuration than shown in FIG. 5. For example, the row decoder 160 may have more, fewer, or different components than shown in FIG. 5.

In some embodiments, the row decoder 160 includes a plurality of row decoder circuits RD0 to RDn. In some embodiments, a row decoder circuit RD is a circuit or a component that can selectively apply voltages to a corresponding block BLK of the memory array 180, according to a block address BAd. The row decoder circuit RD may be implemented as a logic circuit. Each row decoder circuit RD may include, for example, a block decoder BD, transfer gate lines TG and bTG, and transistors TR0 to TR17. In some embodiments, the row decoder circuit RD has a different configuration than shown in FIG. 5. For example, the row decoder circuit RD may have a different number of transistors than shown in FIG. 5.

In some embodiments, the block decoder BD is a circuit or a component that decodes a block address BAd. The block decoder BD may be embodied as a logic circuit. In one configuration, the block decoder BD may be connected to gates of the transistors TR0 to TR17. In this configuration, the block decoder BD may receive a signal or instruction from the sequencer 130 and the block address BAd from the address register 125, and decode the block address BAd based on the signal or instruction from the sequencer 130. The block decoder BD may generate voltages for applying to the transfer gate lines TG and bTG based on the decoding. In one aspect, the voltage applied to the transfer gate line TG and the voltage applied to the transfer gate line bTG may be complementary to each other. In one example, a signal of the transfer gate line TG can be obtained by inverting a signal of the transfer gate line bTG.

In some embodiments, the transistors TR0 to TR17 may be N-type transistors with a high breakdown voltage. The gates of the transistors TR0 to TR12 may be connected in common to the transfer gate line TG. The gates of the transistors TR13 to TR17 may be connected in common to the transfer gate line bTG. Each transistor TR may be connected between a corresponding signal line (e.g., CGO to CG7, SGDDO to SGDD3, SGSD, USGD, USGS) from the driver 150, and a corresponding wiring (e.g., SGS, WL0 to WL7, SGDO to SGD3) provided in the corresponding block BLK.

In one configuration, a drain of the transistor TR0 is connected to the signal line SGSD, and a source of the transistor TR0 is connected to the select gate line SGS. In one configuration, drains of the transistors TR1 to TR8 are connected to the signal lines CGO to CG7, respectively, and sources of the transistors TR1 to TR8 are connected to the word lines WL0 to WL7, respectively. In one configuration, drains of the transistors TR9 to TR12 are connected to the signal lines SGDDO to SGDD3, respectively, and sources of the transistors TR9 to TR12 are connected to the select gate lines SGDO to SGD3, respectively. In one configuration, a drain of the transistor TR13 is connected to the signal line USGS, and a source of the transistor TR13 is connected to the select gate line SGS. In one configuration, drains of the transistors TR14 to TR17 are connected in common to the signal line USGD, and sources of the transistors TR14 to TR17 are connected to the select gate lines SGDO to SGD3, respectively.

In this configuration, the row decoder 160 can select a target block BLK, according to the block address BAd, and apply voltages from the driver 150 to the selected block BLK. In one aspect, each of the transistors TR0 to TR17 can operate as a switch. When a voltage "H" higher than a threshold voltage of a transistor is applied to a gate of the transistor, the transistor can be enabled. When a voltage "L" lower than a threshold voltage of a transistor is applied to a gate of the transistor, the transistor can be disabled. In one approach, the block decoder BD corresponding to a selected block BLK as indicated by the block address BAd can apply a voltage with an "H" level to the transfer gate line TG and a voltage with a "L" level to the transfer gate line bTG. In addition, the block decoder BD corresponding to a non-selected block BLK as indicated by the block address BAd can apply a voltage with an "L" level to the transfer gate line TG and a voltage with a "H" level to the transfer gate line bTG. Hence, voltages generated by the driver 150 can be applied to a selected block BLK through a corresponding row decoder circuit RD via signal lines CGO to CG7, SGDDO to SGDD3, SGSD, while ground voltages (e.g., 0 V) can be applied to a non-selected block BLK through a corresponding non-selected row decoder circuit RD via signal lines USGS, USGD.

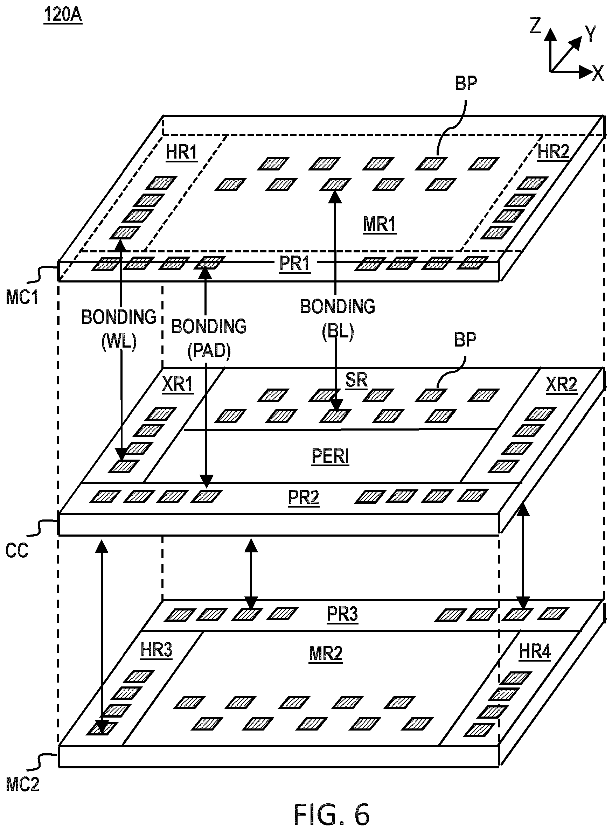

FIG. 6 illustrates a blown-up perspective view of an example structure of a memory device 120A, according to some embodiments. The memory device 120A may be the memory device 120 in FIG. 1. As illustrated in FIG. 6, the memory device 120A may include memory chips MC1, MC2, and a circuit chip CC between the memory chips MC1, MC2 in a Z-direction. The memory chip MC1 may include, for example, a memory array 180, and a part of the row decoder 160. Similarly, the memory chip MC2 may include, for example, another memory array 180, and a part of the row decoder 160. The circuit chip CC may include, for example, the command register 115, the address register 125, the sequencer 130, the sense amplifier 140, and the driver 150, and a part of the row decoder 160. In some embodiments, some features (e.g., logical-to-physical translation) of the memory controller 110 may be also implemented by the circuit chip CC. In some embodiments, the memory device 120A may have a different configuration than shown in FIG. 6.

In some embodiments, a region of the memory chip MC1 is divided into, for example, a memory region MR1, lead regions HR1, HR2, and a pad region PR1. Memory cells may be provided in the memory region MR1. In some embodiments, the memory cells in the memory region MR1 may be NAND flash memory cells. In some embodiments, the memory cells in the memory region MR1 may be static RAM cells, dynamic RAM cells, HBM cells, NOR flash memory cells, MTJ cells, PCM cells, resistive memory cells, or any memory cells. The memory region MR1 may be disposed between, for example, the lead regions HR1 and HR2 in the X direction. The lead regions HR1, HR2 may include a part of circuits (e.g., TRs of the row decoder 160), for example, for providing a voltage or current to one or more word lines. The pad region PR1 may be adjacent to, for example, the memory region MR1 and the lead regions HR1 and HR2 in the Y direction. The pad region PR1 may include wirings for providing signals or voltages to memory cells in the memory region MR1.

In some embodiments, a region of the circuit chip CC is divided into, for example, a sense amplifier region SR, a peripheral circuit region PERI, transfer regions XR1, XR2, and a pad region PR2. In some embodiments, the sense amplifier region SR may include circuits (e.g., the sense amplifier 140), for example, for applying and/or receiving a voltage or current from bit lines of memory arrays in the memory chips MC1, MC2. The peripheral circuit region PERI may include circuits (e.g., the command register 115, the address register 125, the sequencer 130), for example, for controlling various circuits or components of the circuit chip CC. The transfer regions XR1 and XR2 may include circuits (e.g., the driver 150, a part of the row decoder 160), for example, for providing a voltage or current to one or more word lines.

In some embodiments, the sense amplifier region SR and the peripheral circuit region PERI are adjacent to each other in the Y direction. In one configuration, the memory region MR1 of the memory chip MC1 can be disposed above the sense amplifier region SR and the peripheral circuit region PERI in the Z-direction, such that the memory region MR1 can be overlapped with the sense amplifier region SR and the peripheral circuit region PERI when viewed in the Z-direction. In one configuration, the sense amplifier region SR and the peripheral circuit region PERI can be disposed between the transfer regions XR1 and XR2 in the X direction. The lead regions HR1 and HR2 of the memory chip MC1 may be disposed above the transfer regions XR1 and XR2 in the Z-direction, respectively, such that the lead regions HR1 and HR2 may overlap with the transfer regions XR1 and XR2, respectively, when viewed in the Z direction. In one example, input/output circuit to communicate with another device (e.g., memory controller 110 or host device) can be provided in the pad region PR2. The pad region PR1 of the memory chip MC1 may be disposed above the pad region PR2 in the Z-direction, such that the pad region PR1 may overlap with the pad region PR2 when viewed in the Z direction.

In some embodiments, the memory chip MC2 may have the same or a similar configuration as the memory chip MC1, but may be flipped upside down. For example, the memory region MR1, the lead regions HR1, HR2, and the pad region PR1 of the memory chip MC1 may correspond to a memory region MR2, lead regions HR3 and HR4, and a pad region PR3 of the memory chip MC2, respectively. Thus, detailed description of the duplicated portion thereof is omitted herein for the sake of brevity. Although the memory chip MC2 in FIG. 6 is shown as having the same or similar configuration as the memory chip MC1, the memory chips MC1, MC2 may have different configurations in some embodiments.

In some embodiments, the memory chip MC1 has a plurality of bond pads BP on a rear surface facing the circuit chip CC. In some embodiments, the circuit chip CC has a plurality of bond pads BP on a front surface facing the rear surface of the memory chip MC1. Bond pads BP on the front surface of the circuit chip CC can be bonded and connected to corresponding bond pads BP on the rear surface of the memory chip MC1 to allow electrical connections between the memory chip MC1 and the circuit chip CC.

In some embodiments, the memory chip MC2 has a plurality of bond pads BP on a front surface facing the circuit chip CC. In some embodiments, the circuit chip CC has a plurality of bond pads BP on a rear surface (not shown for simplicity) facing the front surface of the memory chip MC2. Bond pads BP on the rear surface of the circuit chip CC can be bonded and connected to corresponding bond pads BP on the front surface of the memory chip MC2 to allow electrical connections between the memory chip MC2 and the circuit chip CC.

Advantageously, the memory device 120A disclosed herein can achieve improved performance and storage density. In one aspect, the circuit chip CC can be formed through a fabrication process different from a fabrication process for the memory chips MC1, MC2. Forming the circuit chip CC through a different fabrication process, for example, in different temperatures, different deposition techniques, and/or different etching techniques can help improve or optimize performances or characteristics (e.g., power consumption, yield, density, speed, etc.) of the memory chips MC1, MC2 and the circuit chip CC. For example, the memory chips MC1, MC2 may operate based on a first power supply voltage (e.g., 3.3 V), where the circuit chip CC may operate based on a second power supply voltage (e.g., 1.2 V) lower than the first power supply voltage. Meanwhile, the memory device 120A disclosed herein implements the circuit chip CC between the memory chips MC1, MC2, where the circuit chip CC can be electrically connected to the memory chips MC1, MC2 through bond pads BP on opposite surfaces of the circuit chip CC. Because bond pads BP on the opposite surfaces of the circuit chip CC can be utilized instead of bond pads BP on a single surface of the circuit chip CC, a sufficient number of bond pads BP can be provided for connection to the memory chips MC1, MC2. Moreover, the memory device 120A can achieve doubled or increased storage density.

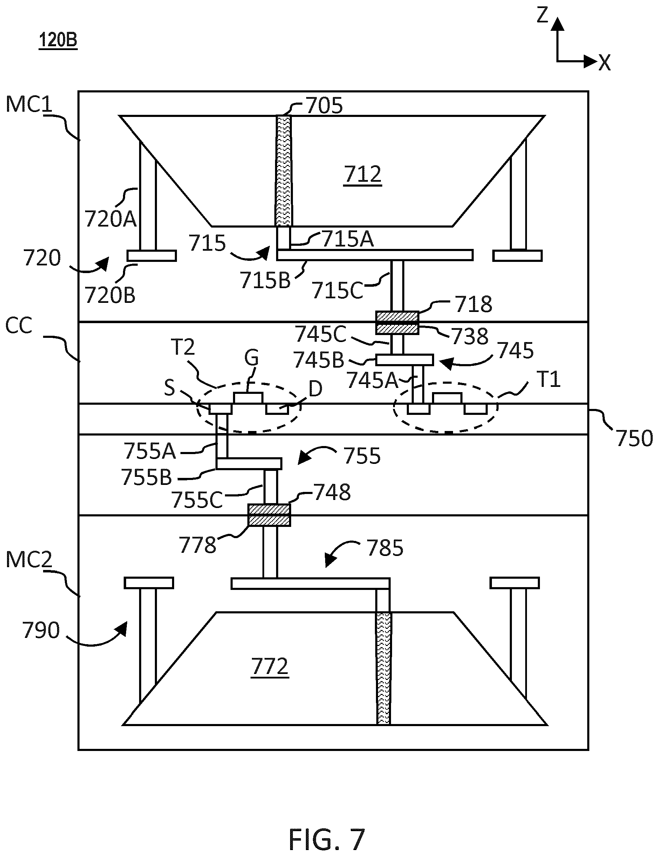

FIG. 7 is a cross-sectional view of a memory device 120B, according to some embodiments. The memory device 120B may be the memory device 120A or a portion of the memory device 120A, in some embodiments. As described above with respect to FIG. 6, the circuit chip CC may be disposed above the memory chip MC2 in the Z-direction, and the memory chip MC1 may be disposed above the circuit chip CC in the Z-direction.

In some embodiments, the memory chip MC1 includes a memory array 712, word line connections 720, bit line connections 715, and bond pads 718. In some embodiments, the memory chip MC1 may include more, fewer, or different components than shown in FIG. 7.

In some embodiments, the memory array 712 includes a plurality of memory cells. The memory array 712 may correspond to the memory array 180 of FIG. 1. The memory array 712 may include a plurality of NAND flash memory cells. For example, the memory array 712 may include alternating stacks of conductor planes and insulator planes that are extending in the X-direction as well as the Y-direction and stacked in the Z-direction. In the memory array 712, semiconductor channels 705 extending in the Z-direction may penetrate the alternating stacks of conductor planes and insulator planes. In one aspect, a NAND flash memory cell can be formed at an intersection of a semiconductor channel 705 and a conductor plane, where the conductor plane extending in the X-direction and the Y-direction may correspond to or function as a word line.

In some embodiments, a word line connection 720 may be a conductive structure for providing signals or voltages to a word line or gates of memory cells in the memory array 712 connected to the word line. In some embodiments, at the ends of the memory array 712 in the X-direction, stepwise structures (shown as slanted portions of the memory array 712) can be provided to expose, in the Z-direction, portions of different conductor planes corresponding to word lines. The exposed portions of the conductor planes can be connected to corresponding word lines connections 720. A word line connection 720 may include segments 720A, 720B. The segment 720A may be a via connect extending in the Z-direction, and may be directly connected to the exposed portion of the conductor plane corresponding to or functioning as the word line. The segment 720B may be a wiring extending in the X-direction, the Y-direction, or both directions, where such wiring may be connected to a corresponding segment 720A (e.g., via connect) of the word line connection 720. The segments 720A, 720B may include conductive materials (e.g., metal) to provide an electrical connection. In some embodiments, the word line connection 720 may include additional segments (e.g., via connects extending in the Z-direction and wirings extending in the X-direction, Y-direction, or both directions) in different layers than shown in FIG. 7.

In some embodiments, a bit line connection 715 may be a conductive structure for providing signals or voltages to bit lines of the memory array 712. In some embodiments, a bit line connection 715 may include segments 715A, 715B, 715C. The segment 715A may be a via connect extending in the Z-direction, and directly connected to a bit line or an end of a corresponding semiconductor channel 705 extending in the Z-direction. The segment 715B may be a wiring extending in the X-direction, the Y-direction, or both directions, where such wiring may be connected to a corresponding segment 715A (e.g., via connect) of the bit line connection 715. The segment 715C may be a via connect extending in the Z-direction, where such via connect may be connected to a corresponding segment 715B (e.g., wiring) of the bit line connection 715 and a bond pad 718. The segments 715A, 715B, 715C may include conductive materials (e.g., metal) to provide an electrical connection. In this configuration, the bit line connection 715 may electrically couple a bit line of the memory array 712 to the bond pad 718. In some embodiments, the bit line connection 715 may include additional segments (e.g., via connects extending in the Z-direction and wirings extending in the X-direction, Y-direction, or both directions) in different layers than shown in FIG. 7.

In some embodiments, a bond pad 718 may correspond to a bond pad BP of the memory chip MC1 shown in FIG. 6. The bond pad 718 may be disposed on a rear surface of the memory chip MC1 facing the circuit chip CC. The bond pad 718 may be bonded to or attached to a bond pad 738 of the circuit chip CC. In this configuration, the bond pad 718 may provide an electrical connection between the circuit chip CC and the bit line connection 715 of the memory chip MC1.

In some embodiments, the memory chip MC2 includes the memory array 772, word line connections 790, bit line connections 785 and bond pads 778. In some embodiments, the memory chip MC2 has a similar configuration as the memory chip MC1, except the memory chip MC2 may be flipped upside down. For example, the memory array 772, word line connections 790, bit line connections 785, and bond pads 778 of the memory chip MC2 may correspond to the memory array 712, word line connections 720, bit line connections 715, and bond pads 718 of the memory chip MC1, respectively. Thus, detailed description of duplicated portion thereof is omitted herein for the sake of brevity. In one aspect, the bond pad 778 may correspond to a bond pad BP of the memory chip MC2 shown in FIG. 6. The bond pad 778 may be disposed on a front surface of the memory chip MC2. The bond pad 778 can be bonded to or attached to a bond pad 748 of the circuit chip CC. Hence, the bond pad 778 may provide an electrical connection between the circuit chip CC and the bit line connection 785 of the memory chip MC2.

In some embodiments, the circuit chip CC includes bond pads 738 on a front surface of the circuit chip CC facing the memory chip MC1, and bond pads 748 on a rear surface of the circuit chip CC facing the memory chip MC2. A bond pad 738 may correspond to a bond pad BP on the front surface of the circuit chip CC in FIG. 6, and a bond pad 748 may correspond to a bond pad BP on the rear surface of the circuit chip CC (not shown in FIG. 6 for simplicity). In some embodiments, the circuit chip CC includes a substrate 750 between the front surface and the rear surface of the circuit chip CC. In some embodiments, the circuit chip CC includes a front side interconnect 745 between the front surface of the circuit chip CC and the substrate 750. In some embodiments, the circuit chip CC includes a backside interconnect 755 between the rear surface of the circuit chip CC and the substrate 750.

In some embodiments, the substrate 750 may be a semiconductor substrate, on which transistors (e.g., T1, T2) can be formed. In some embodiments, the transistors T1, T2 may be MOSFETs, FinFETs, GAAFETs, nanosheet transistors, or any transistors. In some embodiments, the transistors T1, T2 may be formed on the same surface of the substrate 750, which may be referred to as a front surface of the substrate 750. In some embodiments, the transistors T1, T2 may be disposed between the memory array 712 of the memory chip MC1 and the memory array 772 of the memory chip MC2 in the Z-direction. In some embodiments, the transistors T1, T2 may be part of the sense amplifier 140. For example, the transistors T1, T2 may be transistors 410 of different bit line connectors BLHU with a high break down voltage. The transistor T1 may include a gate G, a source S and a drain D, where the source S and the drain D are interchangeable. Similarly, the transistor T2 may include a gate G, a source S and a drain D, where the source S and the drain D are interchangeable.

In some embodiments, the front side interconnect 745 is a conductive structure that provides an electrical connection between the bond pad 738 and the transistor T1. In some embodiments, the front side interconnect 745 includes segments 745A, 745B, 745C. The segment 745A may be a via connect extending in the Z-direction, and directly connected to a front side of the source S (or the drain D) of the transistor T1 facing the memory chip MC1. The segment 745B may be a wiring above the front surface of the substrate 750. The segment 745B may extend in the X-direction, the Y-direction, or both directions, and may be connected to a corresponding segment 745A (e.g., via connect) of the front side interconnect 745. The segment 745C may be a via connect extending in the Z-direction, where such via connect may be connected to a corresponding segment 745B (e.g., wiring) of the front side interconnect 745 and the bond pad 738. The segments 745A, 745B, 745C may include conductive materials (e.g., metal) to provide an electrical connection. In some embodiments, the front side interconnect 745 may include additional segments (e.g., via connects extending in the Z-direction and wirings extending in the X-direction, Y-direction, or both directions) in different layers than shown in FIG. 7. Through the front side interconnect 745, the bond pads 738, 718, and the bit line connection 715, the transistor T1 can be electrically connected to a bit line of a set of memory cells in the memory array 712.

In some embodiments, the backside interconnect 755 is a conductive structure that provides an electrical connection between the bond pad 748 and the transistor T2. In some embodiments, the backside interconnect 755 includes segments 755A, 755B, 755C. The segment 755A may be a via connect extending in the Z-direction, and connected to a rear side of the source S (or the drain D) of the transistor T2 facing the memory chip MC2. The segment 755A may penetrate a rear surface of the substrate 750 facing the memory chip MC2 to directly contact the rear side of the source S (or the drain D) of the transistor T2. In some embodiments, the segment 755B may be a wiring provided below the rear surface of the substrate 750. The segment 755B may extend in the X-direction, the Y-direction, or both directions, and may be connected to a corresponding segment 755A (e.g., via connect) of the backside interconnect 755. In some embodiments, the segment 745B of the front side interconnect 745 and the segment 755B of the backside interconnect 755 may extend in the X-direction, such that one or more transistors on the front surface of the substrate 750 can be disposed between the segments 745B, 755B of interconnects of different sides in the Z-direction. The segment 755C may be a via connect extending in the Z-direction, where such via connect may be connected to a corresponding segment 755B (e.g., wiring) of the backside interconnect 755 and the bond pad 748. The segments 755A, 755B, 755C may include conductive materials (e.g., metal) to provide an electrical connection. In some embodiments, the backside interconnect 755 may include additional segments (e.g., via connects extending in the Z-direction and wirings extending in the X-direction, Y-direction, or both directions) in different layers than shown in FIG. 7. Through the backside interconnect 755, the bond pads 748, 778, and the bit line connection 785, the transistor T2 can be electrically connected to a bit line of a set of memory cells in the memory array 772.

In one aspect, the backside interconnect 755 can provide several advantages. For example, the backside interconnect 755 enables flexible placements or arrangements of various circuit components (e.g., transistors) and bond pads (e.g., 748). Such flexible placements and arrangements of circuit components and bond pads may allow reduction of critical paths and improving performances of the circuit chip CC as well as the memory chips MC1, MC2. For example, the transistor T2 may be disposed above the bond pad 748 in the Z-direction, and may be electrically connected to the bond pad 748 through the backside interconnect 755 below the transistor T2. In one example, due to flexibility in placements and arrangements of circuit components and bond pads, the memory chips MC1, MC2 may have an identical configuration formed by the same fabrication process, such that the fabrication costs can be reduced.

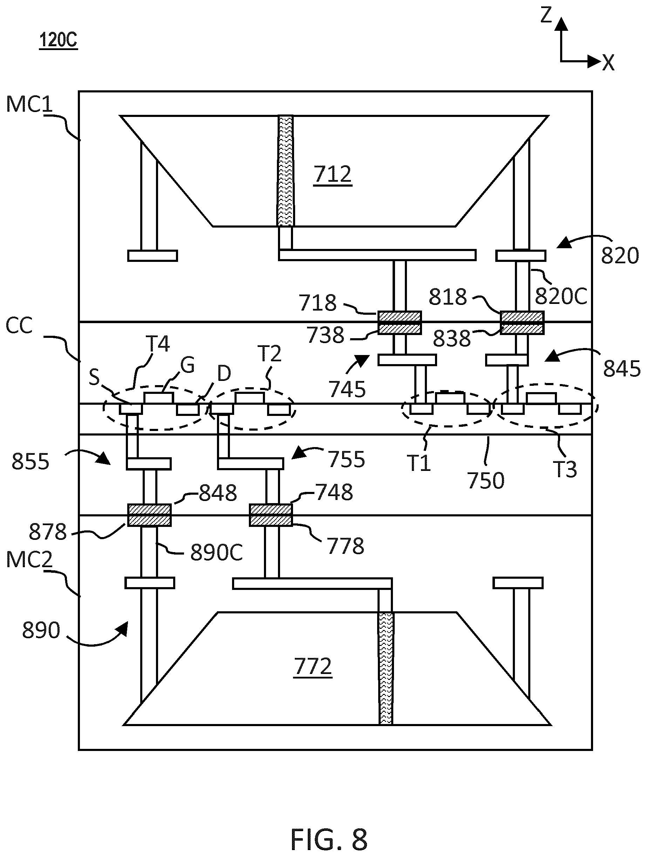

FIG. 8 is a cross-sectional view of a memory device 120C, according to some embodiments. The memory device 120C may be the memory device 120A or a portion of the memory device 120A, in some embodiments. The cross-section of the memory device 120C shown in FIG. 8 is similar to the cross-section of the memory device 120B shown in FIG. 7, except the cross-section of the memory device 120C shown in FIG. 8 includes transistors T3, T4, a front side interconnect 845, a backside interconnect 855, bond pads 818, 838, 848, 878, and the word line connections 820, 890, while omitting the word line connections 720, 790. Thus, detailed description of duplicated portion thereof is omitted herein for the sake of brevity.

In some embodiments, the memory chip MC1 includes the additional bond pad 818 on the rear surface of the memory chip MC1 facing the circuit chip CC. The bond pad 818 may correspond to a bond pad BP of the memory chip MC1 shown in FIG. 6. In some embodiments, the memory chip MC1 also includes the word line connection 820 to electrically connect between i) a word line or gates of memory cells of the memory array 712 connected to the word line and ii) the bond pad 818. The word line connection 820 may be similar to the word line connection 720 of FIG. 7, except the word line connection 820 includes a via connect 820C connected to the bond pad 818 and a wiring extending in the X-direction, the Y-direction or both. The via connect 820C may include conductive materials (e.g., metal). Hence, a word line or gates of memory cells of the memory array 712 connected to the word line can be electrically connected to the bond pad 818 through the word line connection 820.

In some embodiments, the memory chip MC2 includes the additional bond pad 878 on the front surface of the memory chip MC2 facing the circuit chip CC. The bond pad 878 may correspond to a bond pad BP of the memory chip MC2 shown in FIG. 6. In some embodiments, the memory chip MC2 also includes the word line connection 890 to electrically connect between i) a word line or gates of memory cells of the memory array 772 connected to the word line and ii) the bond pad 878. The word line connection 890 may be similar to the word line connection 790 of FIG. 7, except the word line connection 890 includes a via connect 890C connected to the bond pad 878 and a wiring extending in the X-direction, the Y-direction or both. The via connect 890C may include conductive materials (e.g., metal). Hence, a word line or gates of memory cells of the memory array 772 connected to the word line can be electrically connected to the bond pad 878 through the word line connection 890.

In some embodiments, the circuit chip CC includes the bond pad 838 on the front surface of the circuit chip CC facing the memory chip MC1. The bond pad 838 may correspond to a bond pad BP on the front surface of the circuit chip CC shown in FIG. 6. The bond pad 838 of the circuit chip CC may be bonded to or attached to the bond pad 818 of the memory chip MC1. Similarly, the circuit chip CC includes the bond pad 848 on the rear surface of the circuit chip CC facing the memory chip MC2. The bond pad 848 may correspond to a bond pad BP on the rear surface of the circuit chip CC (not shown in FIG. 6 for simplicity). The bond pad 848 of the circuit chip CC may be bonded to or attached to the bond pad 878 of the memory chip MC2.

In some embodiments, the transistors T3, T4 can be formed on the front surface of the substrate 750, on which the transistors T1, T2 are formed. In some embodiments, the transistors T1, T2 can be disposed between the transistors T3, T4 in the X-direction. In some embodiments, the bond pad 838 may be disposed above the transistor T3 in the Z-direction. In some embodiments, the transistor T4 may be disposed above the bond pad 848 in the Z-direction. In some embodiments, the transistors T3, T4 may be MOSFETs, FinFETs, GAAFETs, nanosheet transistors, or any transistors. In some embodiments, the transistors T1, T2, T3, T4 may be same type of transistors. In some embodiments, the transistors T1, T2 and the transistors T3, T4 may be of different types of transistors. For example, the transistors T3, T4 may have a higher breakdown voltage or a different threshold voltage than the transistors T1, T2. In some embodiments, the transistors T3, T4 may be part of the row decoder 160. For example, each of the transistors T3, T4 may be a transistor (e.g., TR0...TR17) from a different row decoder circuit RD. The transistor T3 may include a gate G, a source S and a drain D, where the source S and the drain D are interchangeable. Similarly, the transistor T4 may include a gate G, a source S and a drain D, where the source S and the drain D are interchangeable.

In some embodiments, the circuit chip CC includes the front side interconnect 845 between the front surface of the circuit chip CC and the substrate 750. In one aspect, the front side interconnect 845 has a similar configuration as the front side interconnect 745, but is connected to the front side of a source or drain of the transistor T3 and the bond pad 838, instead of the front side of a source or drain of the transistor T1 and the bond pad 738. Thus, detailed description of duplicated portion thereof is omitted herein for the sake of brevity. In one aspect, through the front side interconnect 845, the bond pads 838, 818, and the word line connection 820, the transistor T3 can be electrically connected to a word line or gates of memory cells of the memory array 712.

In some embodiments, the circuit chip CC includes the backside interconnect 855 between the rear surface of the circuit chip CC and the substrate 750. In one aspect, the backside interconnect 855 has a similar configuration as the backside interconnect 755, but is connected to the rear side of a source or drain of the transistor T4 and the bond pad 848, instead of the rear side of a source or drain of the transistor T2 and the bond pad 748. For example, the backside interconnect 855 may include a segment or a via connect that may penetrate a rear surface of the substrate 750 facing the memory chip MC2 to directly contact the rear side of the source S (or the drain D) of the transistor T4. Thus, detailed description of duplicated portion thereof is omitted herein for the sake of brevity. In one aspect, through the backside interconnect 855, the bond pads 848, 878, and the word line connection 890, the transistor T4 can be electrically connected to a word line or gates of memory cells of the memory array 772.

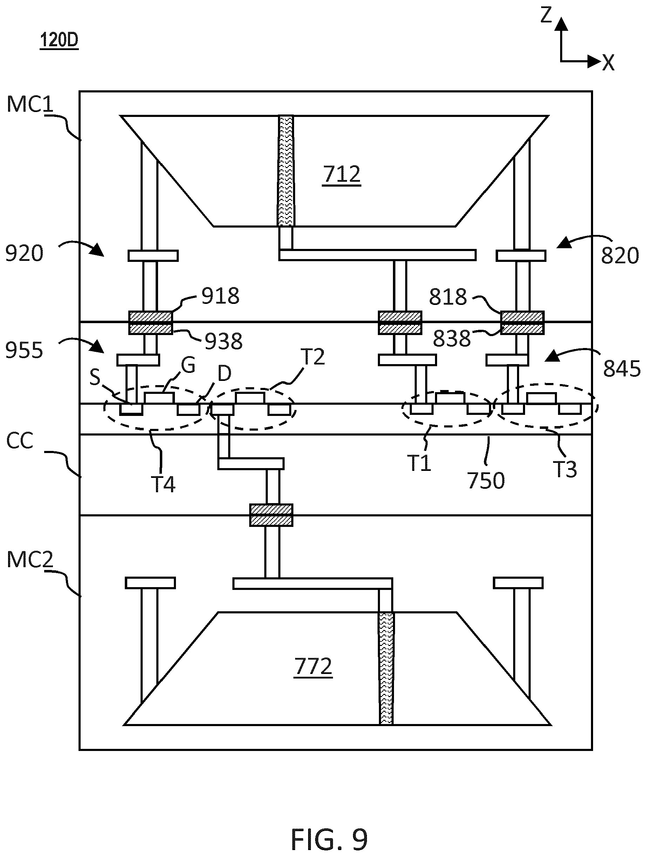

FIG. 9 is a cross-sectional view of a memory device 120D, according to some embodiments. The memory device 120D may be the memory device 120A or a portion of the memory device 120A, in some embodiments. The cross-section of the memory device 120D shown in FIG. 9 is similar to the cross-section of the memory device 120C shown in FIG. 8, except the cross-section of the memory device 120D shown in FIG. 9 includes a front side interconnect 955, bond pads 918, 938 and a word line connection 920 while omitting the backside interconnect 855, the bond pads 848, 878, and the via connect 890C. Thus, detailed description of duplicated portion thereof is omitted herein for the sake of brevity.

In some embodiments, the memory chip MC1 includes the additional bond pad 918 on the rear surface of the memory chip MC1 facing the circuit chip CC. The bond pad 918 may correspond to a bond pad BP of the memory chip MC1 shown in FIG. 6. In some embodiments, the memory chip MC1 also includes the word line connection 920. The word line connection 920 may be similar to the word line connection 820, but is connected to the bond pad 918 instead of the bond pad 818 and is connected to a different word line of the memory array 712. Hence, a word line or gates of memory cells of the memory array 712 connected to the word line can be electrically connected to the bond pad 918 through the word line connection 920. In one aspect, the memory array 712 may be disposed between the word line connections 820, 920 in the X-direction.

In some embodiments, the circuit chip CC includes the bond pad 938 on the front surface of the circuit chip CC facing the memory chip MC1. The bond pad 938 may correspond to a bond pad BP on the front surface of the circuit chip CC shown in FIG. 6. The bond pad 938 of the circuit chip CC may be bonded to or attached to the bond pad 918 of the memory chip MC1.

In some embodiments, the circuit chip CC includes the front side interconnect 955 between the front surface of the circuit chip CC and the substrate 750. In one aspect, the front side interconnect 955 has a similar configuration as the front side interconnect 845, but is connected to the front side of a source or drain of the transistor T4 and the bond pad 938, instead of the front side of a source or drain of the transistor T3 and the bond pad 838. Thus, detailed description of duplicated portion thereof is omitted herein for the sake of brevity. In one aspect, through the front side interconnect 955, the bond pads 938, 918, and the word line connection 920, the transistor T4 can be electrically connected to a word line or gates of memory cells coupled to the word line of the memory array 712.

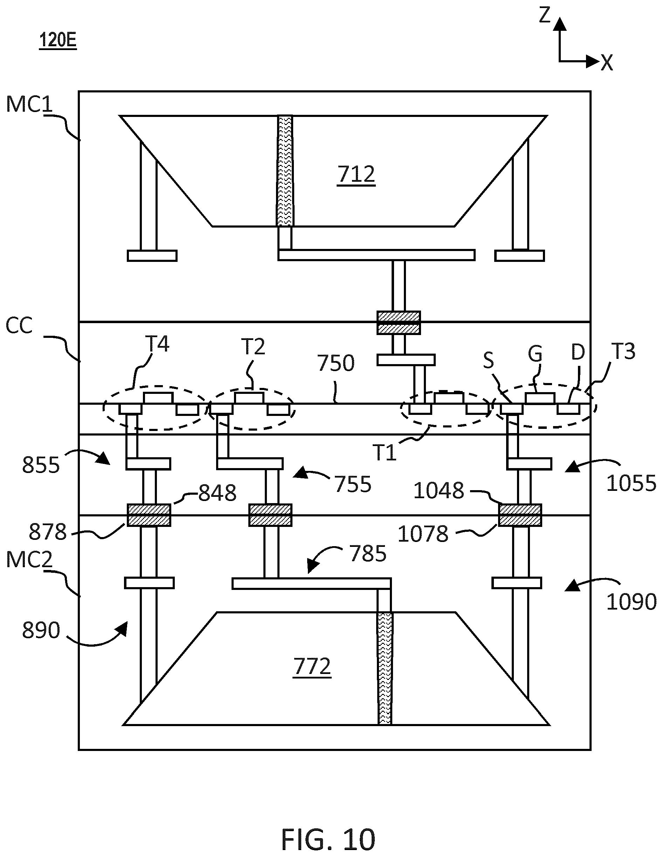

FIG. 10 is a cross-sectional view of a memory device 120E, according to some embodiments. The memory device 120E may be the memory device 120A or a portion of the memory device 120A, in some embodiments. The cross-section of the memory device 120E shown in FIG. 10 is similar to the cross-section of the memory device 120C shown in FIG. 8, except the cross-section of the memory device 120E shown in FIG. 10 includes a backside interconnect 1055, bond pads 1048, 1078 and a word line connection 1090 while omitting the front side interconnect 845, the bond pads 818, 838, and the via connect 820C. Thus, detailed description of duplicated portion thereof is omitted herein for the sake of brevity.

In some embodiments, the memory chip MC2 includes the additional bond pad 1078 on the front surface of the memory chip MC2 facing the circuit chip CC. The bond pad 1078 may correspond to a bond pad BP of the memory chip MC2 shown in FIG. 6. In some embodiments, the memory chip MC2 also includes the word line connection 1090. The word line connection 1090 may be similar to the word line connection 890, but is connected to the bond pad 1078 instead of the bond pad 878 and is connected to a different word line of the memory array 772. Hence, a word line or gates of memory cells of the memory array 772 connected to the word line can be electrically connected to the bond pad 1078 through the word line connection 1090. In one aspect, the memory array 772 may be disposed between the word line connections 890, 1090 in the X-direction.

In some embodiments, the circuit chip CC includes the bond pad 1048 on the rear surface of the circuit chip CC facing the memory chip MC2. The bond pad 1048 may correspond to a bond pad BP on the rear surface of the circuit chip CC (not shown in FIG. 6 for simplicity). The bond pad 1048 of the circuit chip CC may be bonded to or attached to the bond pad 1078 of the memory chip MC2.

In some embodiments, the circuit chip CC includes the backside interconnect 1055 between the rear surface of the circuit chip CC and the substrate 750. In one aspect, the backside interconnect 1055 has a similar configuration as the backside interconnect 855, but is connected to the rear side of a source or drain of the transistor T3 and the bond pad 1048, instead of the rear side of a source or drain of the transistor T4 and the bond pad 848. Thus, detailed description of duplicated portion thereof is omitted herein for the sake of brevity. In one aspect, through the backside interconnect 1055, the bond pads 1048, 1078, and the word line connection 1090, the transistor T3 can be electrically connected to a word line or gates of memory cells of the memory array 772 coupled to the word line. In one aspect, the backside interconnect 755 electrically coupled to a bit line of the memory array 772 is disposed between the backside interconnects 855, 1055 that are electrically coupled to word lines of the memory array 772. The use of the backside interconnects may enable such flexible arrangements and connections on the rear side of the circuit chip CC.

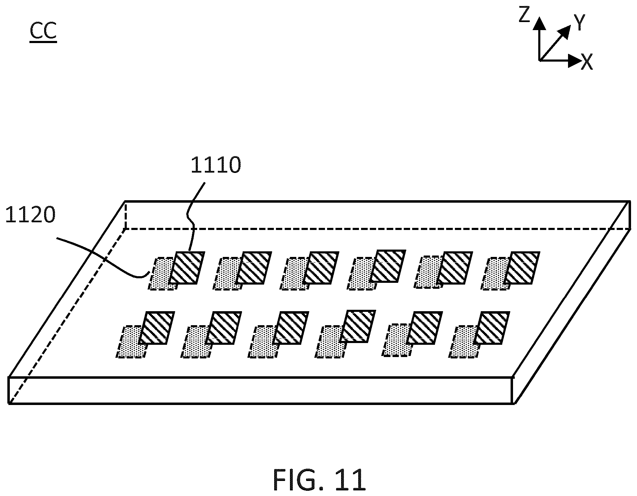

FIG. 11 is a perspective view illustrating bond pads on a portion of the circuit chip CC, according to some embodiments. In some embodiments, the circuit chip CC includes a set of bond pads (e.g., 1110) on the front surface of the circuit chip CC, and a set of bond pads (e.g., 1120) on the rear surface of the circuit chip CC. In some embodiments, the circuit chip CC may include the substrate 750 between the front surface and the rear surface of the circuit chip CC. In one aspect, the bond pad 1110 may be electrically connected to one or more circuits on the substrate 750 through a front side interconnect, and the bond pad 1120 may be electrically connected to one or more circuits on the substrate 750 through a backside interconnect. The bond pad 1110 may partially or fully overlap with the bond pad 1120 when viewed in the Z-direction. Such flexibility in placements of the bond pads on different surfaces with the connections through front side interconnects and backside interconnects disclosed herein may allow improved characteristics (e.g., reduced power consumption and increased operating speed) of the circuit chip CC and the memory chips MC1, MC2, for example, by reducing lengths of interconnects or wirings. Furthermore, a sufficient number of bond pads disposed on opposite surfaces of the circuit chip CC can be utilized to allow various connections between the circuit chip CC and the memory chips MC1, MC2.

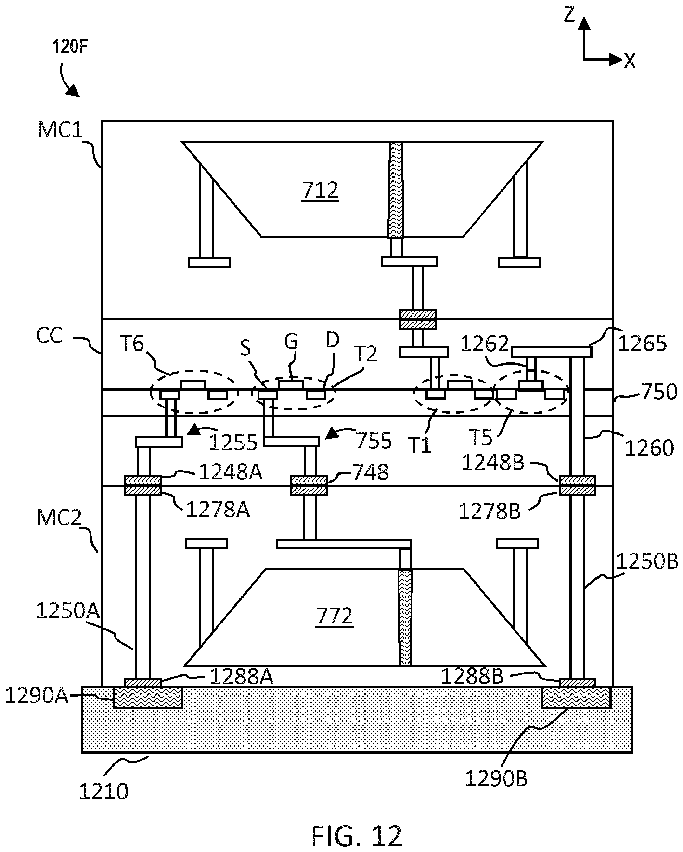

FIG. 12 is a cross-sectional view of a memory device 120F on a printed circuit board (PCB) 1210, according to some embodiments. The memory device 120F may be the memory device 120A or a portion of the memory device 120A, in some embodiments. The cross-section of the memory device 120F shown in FIG. 12 is similar to the cross-section of the memory device 120B shown in FIG. 7, except the cross-section of the memory device 120F shown in FIG. 12 includes bond pads 1248A, 1248B, 1278A, 1278B, 1288A, 1288B, through-via connects (may be also referred to as "through-silicon via connects") 1250A, 1250B, 1260, backside interconnect 1255, wiring 1265, a via connect 1262, and transistors T5, T6. Thus, detailed description of duplicated portion thereof is omitted herein for the sake of brevity.

In some embodiments, the device 100 may include the PCB 1210, on which the memory device 120F can be disposed. In some embodiments, the PCB 1210 includes PCB pads 1290A, 1290B. The PCB pads 1290A, 1290B may include conductive materials (e.g., metal). The PCB pads 1290A, 1290B may be connected to conductive traces on or in the PCB 1210. The conductive traces on or in the PCB 1210 may be connected to another device or integrated circuit (e.g., the memory controller 110 or a host device) on the PCB 1210.

In some embodiments, the memory chip MC2 includes additional bond pads 1288A, 1288B, 1278A, 1278B, and through-via connects 1250A, 1250B. The bond pads 1288A, 1288B can be disposed on the rear surface of the memory chip MC2 facing the PCB 1210. The bond pads 1288A, 1288B can be bonded to or attached to the PCB pads 1290A, 1290B, respectively, to mechanically secure the memory device 120F to the PCB 1210. The bond pads 1278A, 1278B can be disposed on the front surface of the memory chip MC2 facing the circuit chip CC. The bond pads 1278A, 1278B may correspond to bond pads BP on the front surface of the memory chip MC2 in FIG. 6. The through-via connect 1250A may extend in the Z-direction to connect between the bond pads 1278A, 1288A. Similarly, the through-via connect 1250B may extend in the Z-direction to connect between the bond pads 1278B, 1288B. In one aspect, the memory array 772 may be disposed between the through-via connects 1250A, 1250B in the X-direction. The through-via connects 1250A, 1250B may include conductive materials (e.g., metal) to provide electrical connections.

In some embodiments, the circuit chip CC includes the bond pads 1248A, 1248B on the rear surface of the circuit chip CC facing the memory chip MC2. The bond pads 1248A, 1248B may correspond to bond pads BP on the rear surface of the circuit chip CC (not shown in FIG. 6 for simplicity). The bond pads 1248A, 1248B of the circuit chip CC may be bonded to or attached to the bond pads 1278A, 1278B of the memory chip MC2, respectively.

In some embodiments, the transistors T5, T6 can be formed on the front surface of the substrate 750, on which the transistors T1, T2 are formed. In some embodiments, the transistors T1, T2 can be disposed between the transistors T5, T6 in the X-direction. In some embodiments, the transistors T5, T6 may be MOSFETs, FinFETs, GAAFETs, nanosheet transistors, or any transistors. In some embodiments, the transistors T1, T2, T5, T6 may be same type of transistors. In some embodiments, the transistors T1, T2 and the transistors T5, T6 may be of different types of transistors. For example, the transistors T5, T6 may have a higher breakdown voltage or a different threshold voltage than the transistors T1, T2. In some embodiments, the transistors T5, T6 may be part of an input/output circuit of the memory device 120 to communicate with the memory controller 110. The transistor T5 may include a gate G, a source S and a drain D, where the source S and the drain D are interchangeable. Similarly, the transistor T6 may include a gate G, a source S and a drain D, where the source S and the drain D are interchangeable.

In some embodiments, the circuit chip CC includes the backside interconnect 1255 between the rear surface of the circuit chip CC and the substrate 750. In one aspect, the backside interconnect 1255 has a similar configuration as the backside interconnect 755, but is connected to the rear side of a source or drain of the transistor T6 and the bond pad 1248A, instead of the rear side of a source or drain of the transistor T2 and the bond pad 748. For example, the backside interconnect 1255 may include a segment or a via connect that may penetrate a rear surface of the substrate 750 facing the memory chip MC2 to directly contact the rear side of the source S (or the drain D) of the transistor T6. Thus, detailed description of duplicated portion thereof is omitted herein for the sake of brevity.

In some embodiments, the circuit chip CC includes the through-via connect 1260, the wiring 1265, and the via connect 1262 to allow an electrical connection between the bond pad 1248B and the transistor T5. The through-via connect 1260 can be connected to the bond pad 1248B on the rear surface of the circuit chip CC. The through-via connect 1260 can be extended in the Z-direction to penetrate the substrate 750, and connected to the wiring 1265 above the front surface of the substrate 750. The wiring 1265 may extend in the X-direction, the Y-direction, or both. The wiring 1265 may be connected to the via connect 1262 extending in the Z-direction. The via connect 1262 may be connected to the gate of the transistor T5. In this configuration, the gate of the transistor T5 on or above the front surface of the substrate 750 can be electrically connected to the bond pad 1248B on the rear surface of the circuit chip CC through the via connect 1262, the wiring 1265 and the through-via connect 1260.

In this configuration, the circuit chip CC can communicate with another device (e.g., memory controller 110, a host device) through the through-via connects 1250A, 1250B in the memory chip MC2. In one example, the transistor T5 may be part of a receiver circuit that receives a signal or a voltage via the PCB pad 1290B, the bond pad 1288B, the through-via connect 1250B, the bond pads 1278B, 1248B, the through-via connect 1260, the wiring 1265 and the via connect 1262. In one example, the transistor T6 may be part of a transmitter circuit that transmits a signal or a voltage via the backside interconnect 1255, the bond pads 1248A, 1278A, the through-via connect 1250A, the bond pad 1288A, and the PCB pad 1290A. Hence, the circuit chip CC disposed above the memory chip MC2 can be elevated from the PCB 1210 in the Z-direction and still communicate with another device (e.g., memory controller 110, a host device) through connections provided in the memory chip MC2.

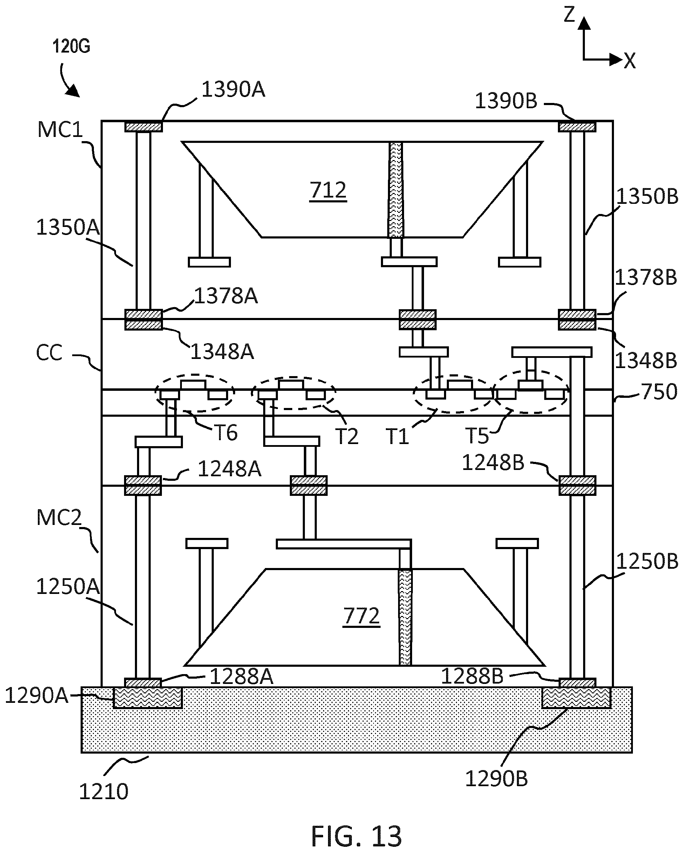

FIG. 13 is a cross-sectional view of a memory device 120G on a PCB 1210, according to some embodiments. The memory device 120G may be the memory device 120A or a portion of the memory device 120A, in some embodiments. The cross-section of the memory device 120G shown in FIG. 13 is similar to the cross-section of the memory device 120F shown in FIG. 12, except the cross-section of the memory device 120G shown in FIG. 13 includes additional bond pads 1348A, 1348B, 1378A, 1378B, 1390A, 1390B and through-via connects 1350A, 1350B. Thus, detailed description of duplicated portion thereof is omitted herein for the sake of brevity.

In some embodiments, the memory chip MC1 includes the bond pads 1390A, 1390B on the front surface of the memory chip MC1, and the bond pads 1378A, 1378B on the rear surface of the memory chip MC1. The bond pads 1378A, 1378B may correspond to bond pads BP on the rear surface of the memory chip MC1 in FIG. 6. The memory chip MC1 may also include the through-via connect 1350A extending in the Z-direction and connected between the bond pads 1390A, 1378A. The memory chip MC1 may also include the through-via connect 1350B extending in the Z-direction and connected between the bond pads 1390B, 1378B. The through-via connects 1350A, 1350B may include conductive materials (e.g., metal). In one aspect, the memory array 712 may be disposed between the through-via connects 1350A, 1350B.

In some embodiments, the circuit chip CC includes bond pads 1348A, 1348B disposed on the front surface of the circuit chip CC facing the memory chip MC1. The bond pads 1348A, 1348B may correspond to bond pads BP on the front surface of the circuit chip CC in FIG. 6. The bond pads 1348A, 1348B may be bonded to or attached to the bond pads 1378A, 1378B of the memory chip MC1, respectively. In some embodiments, the bond pad 1348A may be disposed above the bond pad 1248A and one or more transistors in the Z-direction, but may not be connected to any front side interconnect in the circuit chip CC. In some embodiments, the bond pad 1348B may be disposed above the bond pad 1248B and one or more transistors in the Z-direction, but may not be connected to any front side interconnect in the circuit chip CC. In this configuration, the bond pads 1348A, 1378A, 1390A, and the through-via connect 1350A may be electrically connected to each other, but may not be electrically connected to transistors in the circuit chip CC. Also, the bond pads 1348B, 1378B, 1390B, and the through-via connect 1350B may be electrically connected to each other, but may not be electrically connected to transistors in the circuit chip CC. The bond pads 1348A, 1348B of the circuit chip CC not electrically connected to any component on the substrate 750 of the circuit chip CC may be referred to as dummy bond pads herein. Although such dummy bond pads 1348A, 1348B may not provide electrical connections between the memory chip MC1 and transistors or circuits of the circuit chip CC, bonding of the dummy bond pads 1348A, 1348B with respective bond pads 1378A, 1378B can help mechanically secure the circuit chip CC to the memory chip MC1.

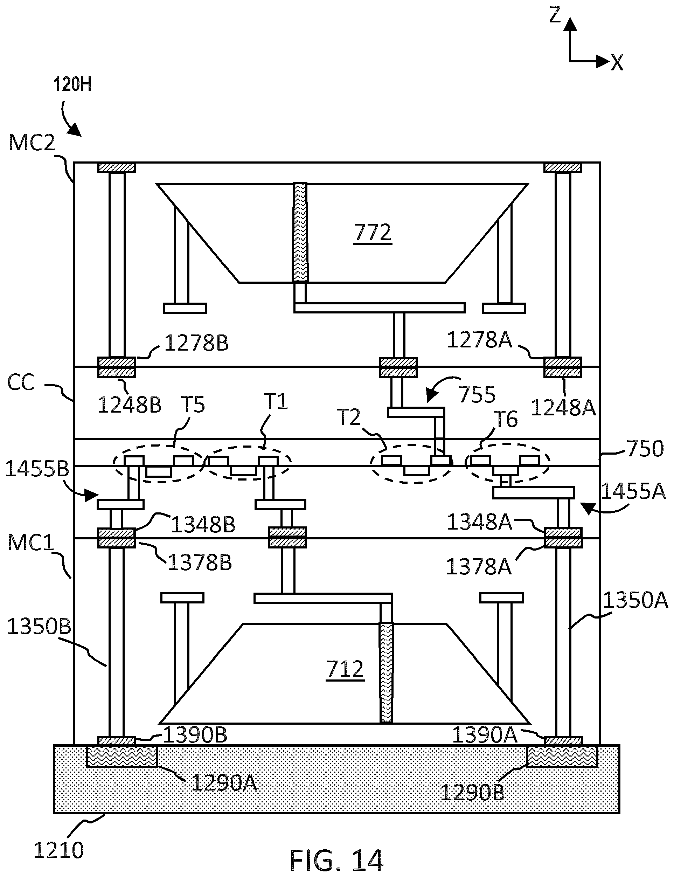

FIG. 14 is a cross-sectional view of a memory device 120H on a PCB 1210, according to some embodiments. The memory device 120H may be the memory device 120A or a portion of the memory device 120A, in some embodiments. The cross-section of the memory device 120H shown in FIG. 14 is similar to the cross-section of the memory device 120G shown in FIG. 13, except the memory device 120H is rotated 180 degrees clock wise compared to the memory device 120G such that the memory chip MC1 is placed on the PCB 1210 instead of the memory chip MC2, and the memory device 120H includes front side interconnects 1455A, 1455B while omitting the backside interconnect 1255, the through-via connect 1260, the wiring 1265, and the via connect 1262. Thus, detailed description of duplicated portion thereof is omitted herein for the sake of brevity.

In some embodiments, the bond pads 1390A, 1390B can be disposed on a surface of the memory chip MC1 facing the PCB 1210. The bond pads 1390A, 1390B can be bonded to or attached to the PCB pads 1290B, 1290A, respectively, to secure the memory device 120H to the PCB 1210. The bond pads 1378A, 1378B can be disposed on a surface of the memory chip MC1 facing the circuit chip CC. The through-via connect 1350A may extend in the Z-direction to connect between the bond pads 1378A, 1390A. Similarly, the through-via connect 1350B may extend in the Z-direction to connect between the bond pads 1378B, 1390B. In one aspect, the memory array 712 may be disposed between the through-via connects 1350A, 1350B in the X-direction. The through-via connects 1350A, 1350B may include conductive materials (e.g., metal) to provide electrical connections.

In some embodiments, the circuit chip CC includes the front side interconnect 1455A, 1455B. The front side interconnect 1455B may have a similar configuration as the front side interconnect 845, except the front side interconnect 1455B may be connected to a front inside of a source or drain of the transistor T5 and the bond pad 1348B instead of a front side of a source or drain the transistor T3 and the bond pad 838. The front side interconnect 1455A may have a similar configuration as the front side interconnect 845, except the front side interconnect 1455A may be connected to a gate of the transistor T6 and the bond pad 1348A instead of a front side of a source or drain the transistor T3 and the bond pad 838. Hence, detailed description of duplicated portion thereof is omitted herein for the sake of brevity.

In this configuration, the transistors T1, T2, T5, T6 can be formed on a surface of the substrate 750 facing the memory chip MC1 and the PCB 1210, where the transistors T1, T2, T5, T6 can be electrically connected to, for example, another device (e.g., memory controller 110 or host device) through the PCB pads 1290A, 1290B, bond pads 1390A, 1390B, through-via connects 1350A, 1350B, bond pads 1348A, 1348B, 1378A, 1378B, and the front side interconnects 1455A, 1455B. Hence, a through-via connect (e.g., through-via connect 1260) penetrating the substrate 750 to electrically connect to a gate of a transistor may be omitted. By omitting a through-via connect penetrating the substrate 750, more surface areas of the substrate 750 can be allocated to accommodate other components (e.g., transistors). Meanwhile, the backside interconnect 755 can be implemented to provide an electrical connection between the memory array 772 of the memory chip MC2 and the transistor T2. Such backside interconnect 755 may allow flexible placements and arrangements of various circuits in the circuit chip CC.

In FIG. 14, the bond pads 1248A, 1248B are disposed on a surface of the circuit chip CC facing the memory chip MC2. The bond pads 1248A, 1248B may be bonded to or attached to the bond pads 1278A, 1278B on the surface of the memory chip MC2, respectively. In some embodiments, the bond pad 1248A may be disposed above the bond pad 1348A and one or more transistors in the Z-direction, but may not be connected to any backside interconnect in the circuit chip CC. Similarly, the bond pad 1248B may be disposed above the bond pad 1348B and one or more transistors in the Z-direction, but may not be connected to any backside interconnect in the circuit chip CC. In this configuration, the bond pads 1248A, 1278A may be electrically connected to each other, but may not be electrically connected to transistors in the circuit chip CC. Also, the bond pads 1248B, 1278B may be electrically connected to each other, but may not be electrically connected to transistors in the circuit chip CC. Hence, the bond pads 1248A, 1248B of the memory device 120H in FIG. 14 may be dummy bond pads. Although such dummy bond pads 1248A, 1248B may not provide electrical connections between the memory chip MC2 and transistors or circuits of the circuit chip CC, bonding of the dummy bond pads 1248A, 1248B with respective bond pads 1278A, 1278B can help mechanically secure the circuit chip CC to the memory chip MC2.

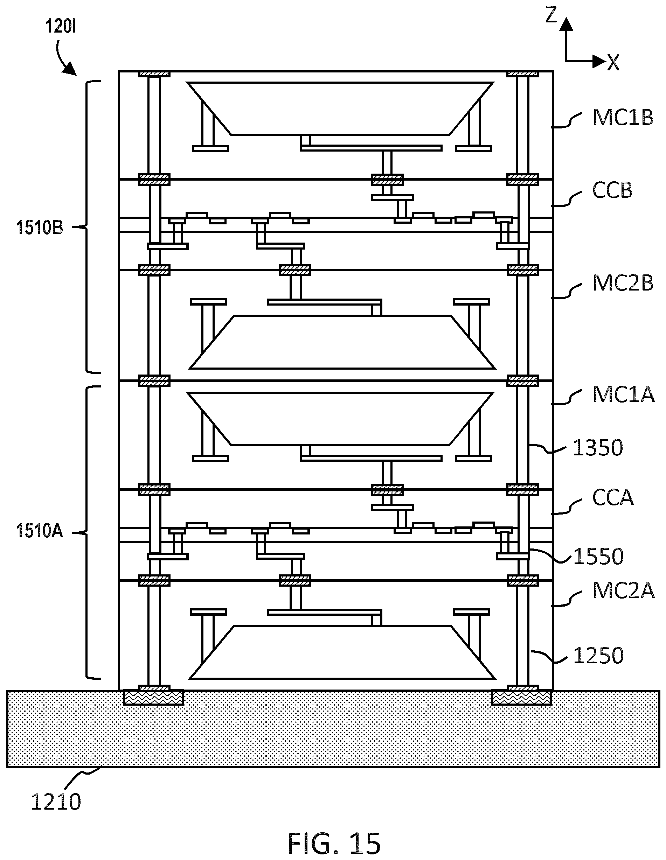

FIG. 15 is a cross-sectional view of a memory device 120I on a PCB 1210, according to some embodiments. In some embodiments, the memory device 120I includes two memory devices 1510A and 1510B stacked in the Z-direction. In some embodiments, the memory device 1510A is disposed on the PCB 1210, and the memory device 1510B is disposed on the memory device 1510A in the Z-direction. Each of the memory devices 1510A, 1510B may be similar to the memory device 120F in FIG. 12, except each circuit chip CC of the memory devices 1510A, 1510B may include through-via connects 1550 extending in the Z-direction between bond pads on opposite surfaces of the circuit chip CC to penetrate a substrate within. Thus, detailed description of duplicated portion thereof is omitted herein for the sake of brevity. In some embodiments, each of the memory devices 1510A, 1510B may include various features of different memory devices (e.g., memory devices 120A through 120H) disclosed herein.

In one aspect, transistors can be electrically connected to the through-via connects 1550 via front side interconnects, backside interconnects or both. The through-via connects 1250, 1350, 1550 provided in memory chips MC and circuit chips CC allow various circuits of circuit chips CC in different memory devices 1510A, 1510B to communicate with each other or with another device (e.g., memory controller 110, a host device, etc.).

In some embodiments, the memory device 1510A includes a memory chip MC2A, a circuit chip CCA, and a memory chip MC1A stacked in the Z-direction. The circuit chip CCA of the memory device 1510A may control operation of the memory chips MC1A, MC2A. In some embodiments, the memory device 1510B includes a memory chip MC2B, a circuit chip CCB, and a memory chip MC1B stacked in the Z-direction. The circuit chip CCB of the memory device 1510B may control operation of the memory chips MC1B, MC2B. Hence, the memory chips MC1A, MC2B can be adjacent to and stacked in the Z-direction, but may be controlled by different circuit chips CCA, CCB, respectively. In one aspect, different circuit chips CC may coordinate and simultaneously perform different operations on respective memory chips MC to improve operation speed. In one aspect, by stacking the memory devices 1510A, 1510B as shown in FIG. 15, storage density of the memory device 120I can be improved. In some embodiments, additional memory devices can be stacked above the memory device 1510B to further increase storage density.

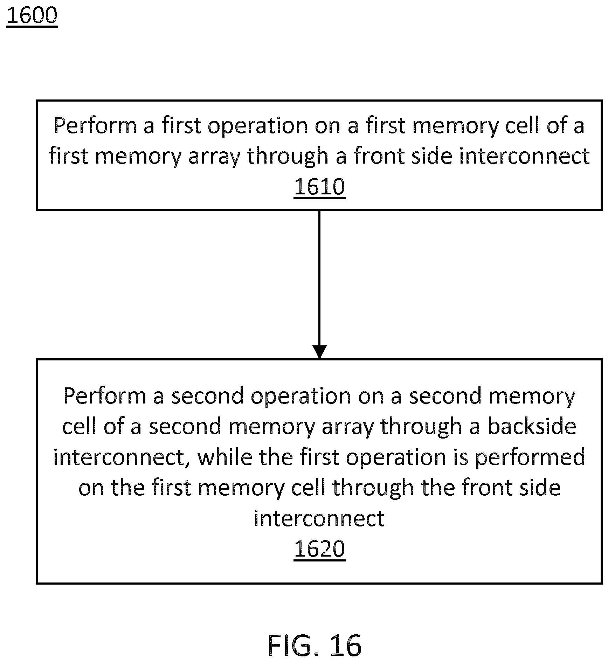

FIG. 16 is a flow chart illustrating an example process 1600 of performing operations on memory chips (e.g., MC1, MC2) with a circuit chip (e.g., CC) in between the memory chips (e.g., MC1, MC2) through interconnects in opposite sides of the circuit chip, according to some embodiments. In some embodiments, the process 1600 can be performed by a circuit chip CC. In some embodiments, the process 1600 can be performed by a different component. In some embodiments, the process 1600 includes more, fewer, or different steps than shown in FIG. 16.

In one approach, the circuit chip CC performs 1610 a first operation on a first memory cell of a first memory array (e.g., 712) through a front side interconnect (e.g., 745, 845, 955, 1455A, 1455B). The first operation may be reading or verifying data stored by the first memory cell, writing data to the first memory cell, or erasing data stored by the first memory cell. For example, a controller (e.g., sequencer 130) may cause the circuit chip CC to apply a voltage or current to the first memory cell through the front side interconnect, or receive a voltage or current from the first memory cell through the front side interconnect to perform the first operation.

In one approach, the circuit chip CC performs 1620 a second operation on a second memory cell of a second memory array (e.g., 772) through a backside interconnect (e.g., 755, 855, 1055, 1255), while the first operation is performed on the first memory cell through the front side interconnect. The second operation may be reading or verifying data stored by the second memory cell, writing data to the second memory cell, or erasing data stored by the second memory cell. For example, the controller may cause the circuit chip CC to apply a voltage or current to the second memory cell through the backside interconnect, or receive a voltage or current from the second memory cell through the backside interconnect to perform the second operation.

In some embodiments, the circuit chip CC may initiate the second operation on the second memory cell of the second memory array through the backside interconnect, while the first operation is performed on the first memory cell of the first memory array through the front side interconnect. In some embodiments, the circuit chip CC may initiate the first operation on the first memory cell of the first memory array through the front side interconnect, while the second operation is performed on the second memory cell of the second memory array through the backside interconnect. In some embodiments, the circuit chip CC may initiate the first operation on the first memory cell of the first memory array through the front side interconnect and the second operation on the second memory cell of the second memory array through the backside interconnect at the same time. Advantageously, different operations can be performed on memory cells in different memory chips through interconnects of different sides, such that the read or write speed can be improved.

Various embodiments disclosed herein are related to a device. In some embodiments, the device includes a first memory chip including a first memory array, and a first bond pad disposed on a surface of the first memory chip. The first bond pad may be coupled to the first memory array. In some embodiments, the device includes a second memory chip including a second memory array, and a second bond pad disposed on a surface of the second memory chip. The second bond pad may be coupled to the second memory array. In some embodiments, the device includes a circuit chip disposed between the first memory chip and the second memory chip. In some embodiments, the circuit chip includes a substrate, a third bond pad disposed on a first surface of the circuit chip facing the first memory chip, and a fourth bond pad disposed on a second surface of the circuit chip facing the second memory chip. The third bond pad may be coupled to the first bond pad of the first memory chip, and the fourth bond pad may be coupled to the second bond pad of the second memory chip. In some embodiments, the circuit chip includes a first transistor and a second transistor disposed on the substrate. The first transistor may be coupled to the third bond pad through a first side interconnect, and the second transistor may be coupled to the fourth bond pad through a second side interconnect. The first side interconnect may be coupled to a first side of the first transistor facing the first memory chip, and the second side interconnect may be coupled to a second side of the second transistor facing the second memory chip.

In some embodiments, a part of the second side interconnect penetrates the substrate to directly contact the second side of the second transistor.

In some embodiments, the first transistor and the second transistor are disposed on a same surface of the substrate.

In some embodiments, the first memory array and the second memory array include non-volatile memory cells.

In some embodiments, the first memory array and the second memory array include volatile memory cells.

In some embodiments, the first bond pad is coupled to a bit line of the first memory array, and the second bond pad is coupled to a bit line of the second memory array.

In some embodiments, the first bond pad is coupled to a word line of the first memory array, and the second bond pad is coupled to a word line of the second memory array.

In some embodiments, the first side interconnect is coupled to the first side of a source/drain of the first transistor, and the second side interconnect is coupled to the second side of a source/drain of the second transistor. The first side of the source/drain of the first transistor may face the first memory chip, and the second side of the source/drain of the second transistor may face the second memory chip.

In some embodiments, the second side interconnect includes a first segment extending in a first direction, where the first segment is coupled to the second side of the source/drain of the second transistor. In some embodiments, the second side interconnect includes a second segment extending in a second direction traversing the first direction, where the second segment is coupled to the first segment.

In some embodiments, the first side interconnect includes a third segment extending in the first direction, where the third segment is coupled to the first side of the source/drain of the first transistor. In some embodiments, the first side interconnect includes a fourth segment extending in the second direction, where the fourth segment is coupled to the third segment.

In some embodiments, the first memory chip is disposed above the second memory chip in a direction, where the third bond pad and the fourth bond pad partially overlap with each other in the direction.

In some embodiments, the first memory chip and the second memory chip have a same configuration.

In some embodiments, the second memory chip further includes a fifth bond pad disposed on the surface of the second memory chip, a sixth bond pad disposed on another surface of the second memory chip, and a first via connect extending in a first direction. The first via connect may be coupled to the fifth bond pad and the sixth bond pad. The second memory array may be disposed above the first via connect in a second direction traversing the first direction.

In some embodiments, the circuit chip further includes a seventh bond pad disposed on the second surface of the circuit chip, where the seventh bond pad is coupled to the fifth bond pad. In some embodiments, the circuit chip further includes a third transistor coupled to the seventh bond pad through an interconnect penetrating the second surface of the substrate.

In some embodiments, the device includes a printed circuit board including a conductive trace coupled to the sixth bond pad. In some embodiments, the device includes a controller coupled to the third transistor through the conductive trace, the sixth bond pad, the first via connect, the fifth bond pad, the seventh bond pad, and the interconnect penetrating the second surface of the substrate.

In some embodiments, the first memory chip further includes an eighth bond pad disposed on the surface of the first memory chip. In some embodiments, the circuit chip further includes a ninth bond pad disposed on the first surface of the circuit chip. The ninth bond pad may be coupled to the eighth bond pad. In some embodiments, the ninth bond pad is disposed above the seventh bond pad in the first direction.

In some embodiments, the second memory chip further includes a seventh bond pad disposed on the surface of the second memory chip, an eighth bond pad disposed on the another surface of the second memory chip, and a second via connect extending in the first direction. The second via connect may be coupled to the seventh bond pad and the eighth bond pad. The second memory array may be disposed between the first via connect and the second via connect in the second direction.

In some embodiments, each of the first memory array and the second memory array includes alternating stacks. In some embodiments, each of the first memory array and the second memory array includes more than one hundred layers of memory cells. In some embodiments, each of the first memory array and the second memory array includes more than two hundred layers of memory cells.

In some embodiments, the circuit chip includes a sense amplifier, one or more word line decoders (or row decoders), and one or more bit line decoders. In some embodiments, the first transistor has a gate length less 70 nm. In some embodiments, each of the first memory chip and the second memory chip includes blocks of memory cells. In some embodiments, the circuit chip further includes a memory controller to manage the blocks of memory cells with a logical-to-physical address translation. In some embodiments, the first memory chip and the second memory chip operate based on a first power supply voltage (e.g., 3.3 V) higher than a second power supply voltage (e.g., 1.2 V), based on which the circuit chip operates.

Various embodiments disclosed herein are related to a device. In some embodiments, the device includes a first memory chip including a first memory array and a first bond pad coupled to the first memory array. In some embodiments, the device includes a second memory chip including a second memory array and a second bond pad coupled to the second memory array. In some embodiments, the device includes a circuit chip disposed between the first memory chip and the second memory chip. In some embodiments, the circuit chip includes a third bond pad coupled to the first bond pad, and a fourth bond pad coupled to the second bond pad. In some embodiments, the circuit chip includes a first transistor coupled to the third bond pad through a front side interconnect, and a second transistor coupled to the fourth bond pad through a backside interconnect. The front side interconnect may be coupled to a front side of the first transistor facing the first memory chip, and the backside interconnect may be coupled to a rear side of the second transistor facing the second memory chip.

In some embodiments, the front side interconnect is coupled to the front side of a source/drain of the first transistor, and the backside interconnect is coupled to the rear side of a source/drain of the second transistor. The front side of the source/drain of the first transistor may face the first memory chip, and the rear side of the source/drain of the second transistor may face the second memory chip.

In some embodiments, the circuit chip performs a first operation on a first memory cell of the first memory array through the front side interconnect. The first operation may be reading or verifying data stored by the first memory cell, writing data to the first memory cell, or erasing data stored by the first memory cell. For example, the circuit chip may apply a voltage or current to the first memory cell through the front side interconnect, or receive a voltage or current from the first memory cell through the front side interconnect to perform the first operation. The circuit chip may perform a second operation on a second memory cell of the second memory array through the backside interconnect, while performing the first operation on the first memory cell through the front side interconnect. The second operation may be reading or verifying data stored by the second memory cell, writing data to the second memory cell or erasing data stored by the second memory cell. For example, the circuit chip may apply a voltage or current to the second memory cell through the backside interconnect, or receive a voltage or current from the second memory cell through the backside interconnect to perform the second operation. In one aspect, the circuit chip can simultaneously perform operations on memory cells in different memory arrays through interconnects of different sides, such that the read or write speed of the circuit chip can be improved.

The previous description is provided to enable any person skilled in the art to practice the various aspects described herein. Various modifications to these aspects will be readily apparent to those skilled in the art, and the generic principles provided herein may be applied to other aspects. Thus, the claims are not intended to be limited to the aspects shown herein, but is to be accorded the full scope consistent with the language claims.

Reference to an element in the singular is not intended to mean "one and only one" unless specifically so stated, but rather "one or more." Unless specifically stated otherwise, the term "some" refers to one or more. No claim element is to be construed as a means plus function unless the element is expressly recited using the phrase "means for." A state of "A coupled to B" or "A connected to B" in a claim herein may encompass i) a state in which A and B are directly connected to each other, as well as ii) a state in which A and B are indirectly connected to each other through one or more components in between.

The various examples illustrated and described are provided merely as examples to illustrate various features of the claims. However, features shown and described with respect to any given example are not necessarily limited to the associated example and may be used or combined with other examples that are shown and described. Further, the claims are not intended to be limited by any one example.

The various illustrative logical blocks, modules, circuits, and algorithm steps described in connection with the examples disclosed herein may be implemented as electronic hardware, computer software, or combinations of both. To clearly illustrate this interchangeability of hardware and software, some components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The hardware used to implement the various illustrative logics, logical blocks, modules, and circuits described in connection with the examples disclosed herein may be implemented or performed with a general purpose processor, a digital signal processor (DSP), an ASIC, a FPGA or other programmable logic device, discrete gate or transistor logic, discrete hardware components, or any combination thereof designed to perform the functions described herein. A general-purpose processor may be a microprocessor, but, in the alternative, the processor may be any processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Alternatively, some steps or methods may be performed by circuitry that is specific to a given function.

## Claims

1. A device comprising:
a first memory chip including:
a first memory array, and
a first bond pad disposed on a surface of the first memory chip, the first bond pad coupled to the first memory array;
a second memory chip including:
a second memory array, and
a second bond pad disposed on a surface of the second memory chip, the second bond pad coupled to the second memory array; and
a circuit chip disposed between the first memory chip and the second memory chip, the circuit chip including:
a substrate,
a third bond pad disposed on a first surface of the circuit chip facing the first memory chip, the third bond pad coupled to the first bond pad of the first memory chip,
a fourth bond pad disposed on a second surface of the circuit chip facing the second memory chip, the fourth bond pad coupled to the second bond pad of the second memory chip,
a first transistor disposed on the substrate, the first transistor coupled to the third bond pad through a first side interconnect, the first side interconnect coupled to a first side of the first transistor facing the first memory chip, and
a second transistor disposed on the substrate, the second transistor coupled to the fourth bond pad through a second side interconnect, the second side interconnect coupled to a second side of the second transistor facing the second memory chip.

2. The device of claim 1, wherein a part of the second side interconnect penetrates the substrate to contact the second side of the second transistor.

3. The device of claim **1,** wherein the first transistor and the second transistor are disposed on a same surface of the substrate.

4. The device of claim **1,** wherein the first memory array and the second memory array include non-volatile memory cells.

5. The device of claim **1,** wherein the first memory array and the second memory array include volatile memory cells.

6. The device of claim 1,
wherein the first bond pad is coupled to a bit line of the first memory array, and
wherein the second bond pad is coupled to a bit line of the second memory array.

7. The device of claim 1,
wherein the first bond pad is coupled to a word line of the first memory array, and
wherein the second bond pad is coupled to a word line of the second memory array.

8. The device of claim 1,
wherein the first side interconnect is coupled to the first side of a source/drain of the first transistor, the first side of the source/drain of the first transistor facing the first memory chip, and
wherein the second side interconnect is coupled to the second side of a source/drain of the second transistor, the second side of the source/drain of the second transistor facing the second memory chip.

9. The device of claim 8, wherein the second side interconnect includes:
a first segment extending in a first direction, the first segment coupled to the second side of the source/drain of the second transistor, and
a second segment extending in a second direction traversing the first direction, the second segment coupled to the first segment.

10. The device of claim 9, wherein the first side interconnect includes:
a third segment extending in the first direction, the third segment coupled to the first side of the source/drain of the first transistor, and
a fourth segment extending in the second direction, the fourth segment coupled to the third segment.

11. The device of claim 1,
wherein the first memory chip is disposed above the second memory chip in a direction, and
wherein the third bond pad and the fourth bond pad partially overlap with each other in the direction.

12. The device of claim 1, wherein the first memory chip and the second memory chip have a same configuration.

13. The device of claim 1, wherein the second memory chip further includes:
a fifth bond pad disposed on the surface of the second memory chip,
a sixth bond pad disposed on another surface of the second memory chip, and
a first via connect extending in a first direction, the first via connect coupled to the fifth bond pad and the sixth bond pad, the second memory array disposed above the first via connect in a second direction traversing the first direction.

14. The device of claim 13, wherein the circuit chip further includes:
a seventh bond pad disposed on the second surface of the circuit chip, the seventh bond pad coupled to the fifth bond pad, and
a third transistor coupled to the seventh bond pad through an interconnect penetrating the second surface of the substrate.

15. The device of claim 14, further comprising:
a printed circuit board including a conductive trace coupled to the sixth bond pad; and
a controller coupled to the third transistor through the conductive trace, the sixth bond pad, the first via connect, the fifth bond pad, the seventh bond pad, and the interconnect penetrating the second surface of the substrate.

16. The device of claim 14,
wherein the first memory chip further includes an eighth bond pad disposed on the surface of the first memory chip, and
wherein the circuit chip further includes a ninth bond pad disposed on the first surface of the circuit chip, the ninth bond pad coupled to the eighth bond pad.

17. The device of claim 16, wherein the ninth bond pad is disposed above the seventh bond pad in the first direction.

18. The device of claim 13, wherein the second memory chip further includes:
a seventh bond pad disposed on the surface of the second memory chip,
an eighth bond pad disposed on the another surface of the second memory chip, and
a second via connect extending in the first direction, the second via connect coupled to the seventh bond pad and the eighth bond pad, the second memory array disposed between the first via connect and the second via connect in the second direction.

19. A device comprising:
a first memory chip including a first memory array and a first bond pad coupled to the first memory array;
a second memory chip including a second memory array and a second bond pad coupled to the second memory array; and
a circuit chip disposed between the first memory chip and the second memory chip, the circuit chip including:
a third bond pad coupled to the first bond pad,
a fourth bond pad coupled to the second bond pad,
a first transistor coupled to the third bond pad through a front side interconnect, the front side interconnect coupled to a front side of the first transistor facing the first memory chip, and
a second transistor coupled to the fourth bond pad through a backside interconnect, the backside interconnect coupled to a rear side of the second transistor facing the second memory chip.

20. The device of claim 19,
wherein the front side interconnect is coupled to the front side of a source/drain of the first transistor, the front side of the source/drain of the first transistor facing the first memory chip, and
wherein the backside interconnect is coupled to the rear side of a source/drain of the second transistor, the rear side of the source/drain of the second transistor facing the second memory chip.
